Europäisches Patentamt

European Patent Office

Office européen des brevets

(19)

(11) Veröffentlichungsnummer: **0 230 437 B1**

(12) # EUROPÄISCHE PATENTSCHRIFT

(45) Veröffentlichungstag der Patentschrift: 23.10.91

(51) Int. Cl.⁵: **H04N 1/417**, H03M 7/46

(21) Anmeldenummer: 86904098.0

(22) Anmeldetag: 16.07.86

(86) Internationale Anmeldenummer:
PCT/DE86/00289

(87) Internationale Veröffentlichungsnummer:
WO 87/00714 (29.01.87 87/03)

(54) **VERFAHREN ZUM KOMPRIMIEREN UND DEKOMPRIMIEREN MEHRERER STRUKTURVERWANDTER DATENFOLGEN SOWIE EINRICHTUNGEN ZUR DURCHFÜHRUNG DES VERFAHRENS.**

(30) Priorität: 19.07.85 DE 3525898

(43) Veröffentlichungstag der Anmeldung:
05.08.87 Patentblatt 87/32

(45) Bekanntmachung des Hinweises auf die
Patenterteilung:
23.10.91 Patentblatt 91/43

(84) Benannte Vertragsstaaten:
CH DE FR GB IT LI NL

(56) Entgegenhaltungen:
FR-A- 2 298 834
US-A- 3 394 354
US-A- 3 504 112
US-A- 3 521 241

IEEE Transactions on Aerospace and Electronic Systems, volume AES-2, No. 4, July 1966, IEEE, New York (US) J.W. Schwartz et al.: "Bit-plane encoding a technique for source encoding" pages 385-392

(73) Patentinhaber: **WIEBACH, Heinz-Ulrich**
**Gladiolenweg 57b**
**W-6382 Friedrichsdorf(DE)**

(72) Erfinder: **LIDZBA, Reinhard**
**Im Mainfield 23/4.6**
**W-6000 Frankfurt 71(DE)**
Erfinder: **WIEBACH, Heinz-Ulrich**
**Gladiolenweg 57b**
**W-6382 Friedrichsdorf(DE)**

(74) Vertreter: **Schaumburg, Thoenes & Englaender**
**Mauerkircherstrasse 31 Postfach 86 07 48**
**W-8000 München 86(DE)**

IEEE National Telecommunications Conference, 26-28 November 1973, IEEE, New York (US) D.R. Klose: "Data compaction for improved transmission efficiency", pages 35C-1-35C-6

IBM Technical Dislosure Bulletin, volume 14, No. 7, December 1971, New York (US) E.T. Eiselen: "Raster menory scannable by row or column" pages 1984-1985

**Beschreibung**

Die Erfindung betrifft ein Verfahren zum Komprimieren und Dekomprimieren mehrerer strukturverwandter Datenfolgen, nach dem Oberbegriff des Patentanspruchs 1. Ferner betrifft die Erfindung Datenverarbeitungseinrichtungen zur Durchführung das Verfahrens.

Datenfolgen sind häufig in hohem Maße redundant, d.h. sie enthalten eine wesentlich größere Zahl von Datenelementen oder Zeichen, als sie zur Darstellung der jeweils enthaltenen Information erforderlich wäre. Ein Beispiel hierfür sind die regelmäßig aufgebauten Datensätze von Dateien aus Wirtschaft und Verwaltung. Ein weiteres Beispiel hierfür ist die Übertragung von Fernsehbildern, bei denen die nacheinander aufgenommenen und dann als Datenfolgen gespeicherten oder übertragenen Teilbilder bezüglich einzelner Bereiche einer Szene identisch sind, weil sie dort keine Änderung hinsichtlich der Lage, Helligkeit oder Farbe der Bildpunkte erfahren haben. Das ist ohne Szenenwechsel für die meisten Bildpunkte der Fall. Um die Übertragung von Datenfolgen wirtschaftlich vornehmen zu können, ist es erforderlich, diese zu komprimieren und am Ende der Übertragungsstrecke wieder zu dekomprimieren.

Es sind bereits Verfahren bekannt, bei denen die Verdichtung der Datenfolgen über eine Codierung veränderlicher Länge vorgenommen wird. Ein Codierschema dieses Typs bewirkt, daß Bitreihen fest vorgegebener Länge in Bitreihen veränderlicher Länge umcodiert werden, wobei die häufiger vorkommenden Codeworte von Bitreihen dargestellt werden, die kürzer sind als die der Codeworte fest vorgegebener Länge. Diese Umwandlung von Codeworten fester Länge in Codeworte veränderlicher Länge ist als Huffman-Codierung bekannt. Bei sinnvoller Zuordnung von Codeworten veränderlicher Länge ergibt sich bei gegebenen Daten dann eine wesentlich geringere Länge derartiger Codeworte gegenüber den entsprechenden Codeworten fest vorgegebener Länge, obwohl viele Codeworte veränderlicher Länge wesentlich länger als die entsprechenden Codeworte fester Länge sind.

Es sind ferner Verfahren zum Komprimieren und Dekomprimieren von Datenfolgen bekannt, bei denen eine Strukturanalyse vorgenommen wird, um bei einer vorgegebenen Zahl von Datenelementen der Datenfolgen eine diese verbindende Charakteristik zu erkennen. Eine solche Charakteristik kann beispielsweise im mehrmaligen Auftreten desselben Zeichens liegen oder auch bei einer aufsteigenden numerischen Ziffernfolge der Art 1, 2 ... n gegeben sein. Die vorgegebene Zahl von Datenelementen wird dann in einen Code umgesetzt. Bei einer Zeichenkette von n gleichen Zeichen müßte ein solcher Code mindestens ein Trennzeichen, das betreffende Zeichen und die Anzahl seines Auftretens enthalten, um beim Dekomprimieren die ursprüngliche Zeichenkette durch Decodieren des Codes wieder herstellen zu können.

Es ist ferner ein Verfahren zum Komprimieren und Dekomprimieren von Datenfolgen bekannt, bei dem zwei logisch verwandte Datenfolgen vor dem eigentlichen Komprimieren herkömmlicher Art EXKLUSIV-ODER verknüpft werden. Diese logische Verknüpfung bewirkt, daß an den Stellen, an denen gleiche Zeichen vorhanden sind, Nullen erzeugt werden. Da die Datenfolgen, wie vorausgesetzt, logisch verwandt sind, wird durch die EXKLUSIV-ODER-Verknüpfung eine Datenfolge erzeugt, die als Datenelemente häufig Nullen enthält. Die mit Nullen stark durchsetzte Datenfolge wird dann nach herkömmlicher Art komprimiert.

Bei diesem Verfahren wird die Strukturverwandtschaft, insbesondere die logische Verwandtschaft, zumindest zweier Datenfolgen zum Zwecke des Komprimierens genützt, um das Komprimierungsergebnis zu verbessern, aber auch bei diesem Verfahren ist das Komprimierungsergebnis noch stark redundant. Außerdem benötigt man zur Durchführung einen hohen schaltungstechnischen Aufwand, da Universalrechner hoher Leistung erforderlich sind.

Gleiches gilt für ein Verfahren der eingangs genannten Art, das aus dem Aufsatz "Data Compaction for Improved Transmission Efficiency" von Dirk R. Klose in IEEE National Telecommunications Conference, 26.-28. November 1973, Seiten 35C-1 bis 35C-6, bekannt ist. Bei diesem Verfahren werden mehrere Datenfolgen vorbestimmter Länge, die zusammen einen Datensatz bilden, zeilenweise in einer Matrix angeordnet und durch spaltenweises Umschlüsseln in weniger redundante Codefolgen komprimiert, indem ihre Strukturverwandtschaft in Spaltenrichtung festgestellt und ausgewertet wird. Hierdurch läßt sich zwar das Komprimierungsergebnis verbessern, jedoch bleibt der schaltungstechnische Aufwand insbesondere für die spaltenweise Betrachtung der matrixartig angeordneten Datenfolgen hoch.

Aus der US-A-3 521 241 ist ferner ein Verfahren zum zweidimensionalen Komprimieren von Daten bekannt, die in Binärdarstellung vorliegen und die durch das Abscannen von Dokumenten oder Bildern aus Videosignalen gewonnen werden. Diese Daten werden in einer Matrix gespeichert und einer zweimaligen Datenkomprimierung unterzogen, die einmal zeilenweise und das andere Mal spaltenweise durchgeführt wird. Die zur Gewinnung einer eine Anzahl von Datenelementen verbindende Charakteristik angewandte Strukturanalyse von Datenelementen gleicher Ordnungszahl in der Matrix beruht auf dem Prinzip der Lauflängencodierung, bei der eine Anzahl gleicher Datenelemente einer Datenfolge zusammengefaßt werden.

Ein weiteres Verfahren zur Speicherplatzminimierung durch Komprimieren von Daten, die für Halbtonbilddruck bestimmt sind, wird in der FR-A-2 298 834 beschrieben. Bei diesem Verfahren werden Bildpunkte jeweils in einer Matrix mit schwarzen und weißen Punktelementen dargestellt. Die Verteilung der Punktelemente in der Matrix bestimmt den Grauwert des Bildpunktes. Diese Verteilung wird in codierter Form, z.B. in Zahlen, in einem Computer gespeichert. Zur Speicherreduzierung werden die Zahlen einer Datenkompression unterzogen, die z.B. nach der bekannten Huffman-Codeoptimierung oder nach einer logarithmischen Codeoptimierung erfolgen kann. Bei diesen Codeoptimierungen werden die Anzahl des Auftretens gleichartiger, nebeneinander liegender Bildelemente festgestellt. Diese Anzahl wird als Längenwert bezeichnet. Die vorkommenden Längenwerte werden einer Wahrscheinlichkeitsanalyse unterzogen, und jedem Längenwert wird abhängig von seiner Wahrscheinlichkeit ein bestimmter Code zugeordnet.

Es ist daher Aufgabe der Erfindung, eine Möglichkeit des Einwirkens auf die Datenfolgen anzugeben, durch die das Komprimieren und Dekomprimieren mehrerer strukturverwandter Datenfolgen, insbesondere Datensätze, auch im Ergebnis gegenüber bisherigen Verfahren so deutlich verbessert wird, daß es durch einen weit geringeren schaltungstechnischen Aufwand realisiert werden kann als es bisher unumgänglich war.

Diese Aufgabe wird ausgehend von einem Verfahren eingangs genannter Art erfindungsgemäß dadurch gelöst, daß vor der Strukturanalyse die gespeicherten Datenfolgen auf ihre Länge untersucht, mit Datenfolgen gleicher Länge Datenfolgengruppen gebildet und die Datenfolgengruppen nach zunehmender oder abnehmender Länge geordnet werden.

Durch den gemäß der Erfindung vor der Strukturanalyse durchgeführten besonderen Verfahrensschritt wird es möglich, bei der spaltenweise durchzuführenden Strukturanalyse und Komprimierung der Datenelemente nur denjenigen Teil der jeweiligen Matrixspalte zu berücksichtigen, in dem infolge der vorgesehenen Ordnung der Datenfolgengruppen Informationen vorhanden sind. Dadurch läßt sich der Aufwand an Verarbeitungszeit und damit Schaltungstechnik wesentlich verringern, und gleichzeitig wird das Komprimierungsergebnis weiter verbessert, weil die vor der Strukturanalyse durchgeführte Ordnung der Datenfolgengruppen nach ihrer Länge ein zusammenfassendes Betrachten benachbarter Matrixspalten gleicher oder auch nahezu gleicher Länge ermöglicht, wodurch einzelne Matrixspalten einer derartigen Gruppe kennzeichnende Codezeichen beim Komprimieren eingespart werden. Es hat sich gezeigt, daß bei einer derartigen Ordnung der Datenfolgengruppen auch andere gemeinsame Merkmale einander benachbarter Matrixspalten leichter auswertbar sind und zu einer Verkürzung der Codeworte im Komprimierungsergebnis führen können.

Werden geordnete Datenfolgen gleicher effektiver Länge auf übereinstimmende Datenfolgecharakteristik, beispielsweise Satzart, letztes Zeichen einer Datenfolge oder Anzahl der Datenelemente einer Datenfolge untersucht, und entsprechend geordnet, so werden Datenfolgen mit gleicher oder auch ähnlicher Charakteristik und damit großer Strukturähnlichkeit näher zusammengebracht, wodurch das Komprimierungsergebnis weiter verbessert werden kann.

Werden geordnete Datenfolgen gleicher effektiver Länge und gleicher Charakteristik noch nach zunehmender oder abnehmender Speichermatrix-Zeilennummer geordnet, um die Strukturverwandtschaft der nacheinander zeilenweise in die Speichermatrix eingelesenen Datenfolgen möglichst zu erhalten, so kann das Komprimierungsergebnis dadurch weiter verbessert werden.

Vorteilhaft können dabei die effektive Datenfolgelänge, mindestens eine Datenfolgecharakteristik und die Speichermatrix-Zeilennummer durch ein Attributfeld gekennzeichnet werden, das jede Datenfolge ergänzt. Es kann dann auf diese Ordnungskriterien leicht zugegriffen werden.

In einer weiteren Ausbildung des erfindungsgemäßen Verfahrens werden die einzelnen Datenfolgen seriell vorkomprimiert, um die bei serieller Betrachtung gegebene Strukturverwandtschaft der Datenelemente der einzelnen Datenfolgen zu nützen. Dabei sollten die strukturellen Bezugspunkte für die eigentliche spaltenweise Komprimierung möglichst nicht zerstört werden. Dies wird dadurch erreicht, daß die verdichteten Zeichenketten in der Datenfolge durch Füllzeichen ersetzt werden, die bei der eigentlichen spaltenweisen Komprimierung nicht beachtet werden. Auf diese Weise bleibt die Struktur der einzelnen Datenfolgen erhalten.

Als eine Möglichkeit der seriellen Vorkomprimierung wird das jeweils letzte Datenelement mindestens einer Datenfolge sowie ggf. die Zahl solcher Datenelemente, also ihr Wiederholungsfaktor, in das Attributfeld übernommen. Ferner werden das letzte Datenelement sowie seine mit ihm übereinstimmenden unmittelbaren Vorgänger in der Datenfolge zur Verkürzung eliminiert. Diese Art der seriellen Vorkomprimierung erweist sich als besonders vorteilhaft, da die letzten Datenelemente einer Datenfolge häufig übereinstimmen. Man denke dabei z.B. an Leerzeichen, sogenannten Blanks, am Ende der Datenfolgen.

Wenn die Art einer Datenfolge nicht explizit angegeben ist, so hat es sich als vorteilhaft erwiesen, das letzte und das vorletzte Datenelement der unverkürzten Datenfolge als Datenfolgecharakteristik in das Attributfeld zu übernehmen und in der Datenfolge zu eliminieren. Dies beruht vor allem auf der Erkenntnis, daß strukturähnliche Datenfolgen häufig in ihren Datenelementen am Datenfolgeende übereinstimmen.

Das Komprimierungsergebnis kann weiter verbessert werden, wenn im Rahmen der seriellen Vorkomprimierung der Datenfolgen mindestens die längste aus gleichen Datenelementen bestehende Zeichenkette einer Datenfolge eliminiert und durch Füllzeichen ersetzt wird und wenn diese Zeichenkette in einem für jede Datenfolge separat vorgesehenen Deskriptorfeld durch einen den Zeichenkettenanfang markierenden Zeiger, durch die Zeichenkettenlänge und durch das ersetzte Zeichen beschrieben wird. Mit dieser Maßnahme können lange Zeichenketten übereinstimmender Datenelemente höchst effektiv komprimiert werden, ohne daß dadurch die Struktur der einzelnen Datensätze zerstört wird, da die eliminierten Zeichenketten durch Füllzeichen ersetzt werden, die bei der eigentlichen spaltenweisen Komprimierung nicht berücksichtigt werden.

Da sich die Flatterung (fließsatzartige Anordnung) von beispielsweise Leerzeichen oder Nullzeichen auf das Komprimierungsergebnis bei der spaltenweisen Komprimierung negativ auswirkt, wird im Rahmen der seriellen Vorkomprimierung mindestens die größte Flatterung solcher Störzeichen bei den zu komprimierenden Datenfolgen festgestellt, werden die Störzeichen durch Füllzeichen ersetzt und wird das Störzeichen selbst durch einen den Störzeichenfeldanfang markierenden Flatterungszeiger, durch die Feldlänge und durch das ersetzte Störzeichen beschrieben.

Da sämtliche im Rahmen der seriellen Vorkomprimierung beschriebenen Maßnahmen ebenso wie die Sortierung der Datenfolgen aufgrund verschiedener Kriterien eineindeutige Vorgänge sind, können sie im Rahmen der Dekomprimierung wieder rückgängig gemacht werden.

In einer weiteren Ausbildung des erfindungsgemäßen Verfahrens wird für jede Datenelementspalte jeweils mindestens ein Spaltendeskriptorfeld vorgesehen, das die Datenelementspalte zumindest teilweise beschreibt. Es ist dadurch gemäß einer Weiterbildung der Erfindung beispielsweise möglich, daß aus gleichen Zeichen bestehende Datenelementspalten eliminiert, durch Füllzeichen ersetzt und in den betreffenden Deskriptorfeldern durch Angabe des jeweils ersetzten Zeichens beschrieben werden. Durch das Einfügen der Füllzeichen anstelle der eliminierten Datenspalte bleibt die Struktur der einzelnen Datenfolgen erhalten, weil die Füllzeichen bei der eigentlichen spaltenweisen Komprimierung übergangen werden.

Gemäß einer anderen Weiterbildung der Erfindung wird zumindest die längste aus gleichen Datenelementen bestehende Zeichenkette einer Datenelementspalte eliminiert und durch Füllzeichen ersetzt. Ferner wird diese Zeichenkette im jeweiligen Spaltendeskriptorfeld durch einen den Zeichenkettenanfang markierenden Zeiger, durch die Zeichenkettenlänge und durch das ersetzte Zeichen beschrieben. Durch diese Beschreibung der Zeichenkette ist es möglich, sie im Rahmen der Dekomprimierung wiederherzustellen und an richtiger stelle in der Datenelementspalte anzuordnen.

Bei einer anderen Weiterbildung des erfindungsgemäßen Verfahrens wird zumindest die längste aus gleichen Datenelementen bestehende Zeichenkette einer Datenelementspalte in ein im Vergleich zur betreffenden Zeichenkette kürzeres Codewort umcodiert und durch dieses ersetzt und werden die dabei freiwerdenden Datenelementplätze mit Füllzeichen aufgefüllt.

In einer weiteren vorteilhaften Ausbildung des erfindungsgemäßen Verfahrens werden zwei benachbarte Zeichenketten einer Datenelementspalte vertauscht und werden ein die Berührungsstelle der Zeichenketten in ihrer ursprünglichen Lage markierender Zeiger und die Längen der Zeichenketten im Deskriptorfeld der betreffenden Datenelementspalte gespeichert. Diese Vertauschung zweier benachbarter Zeichenketten bewirkt eine Homogenisierung der Daten der betreffenden Datenelementspalte.

In einer Weiterbildung des erfindungsgemäßen Verfahrens werden die Datenelemente mindestens eines Teils einer Datenelementspalte in einen für diese betreffende Spalte spezifischen, weniger redundanten Code umgeschlüsselt, wodurch das Komprimierungsergebnis weiter verbessert werden kann.

Als weitere Maßnahme zur Verbesserung des Komprimierungsergebnisses dient die Verknüpfung der einzelnen Datenelemente einer Datenelementspalte durch die logische Funktion mit der Wahrheitstabelle "A verknüpft mit B = W", falls A = B und "A verknüpft mit B = B", falls A ≠ B unter der Bedingung B ≠ W, wobei W ein beliebiges Wiederholungszeichen, z.B. das Nullzeichen, ist. Die Anwendung dieser logischen Funktion auf die Datenelemente einer Datenelementspalte dient der Homogenisierung dieser Datenelemente. Wird bei einem Vergleich des Datenelements B mit dem Datenelement A die Gleichheit von B und A festgestellt, so wird das Datenelement B durch das Wiederholungszeichen W ersetzt. Wird dagegen bei einem Vergleich des Datenelements B mit dem Datenelement A die Ungleichheit von B und A festgestellt, so bleibt das Datenelement B unverändert. Wenn man diese logische Funktion auf die Datenelemente nacheinander, beispielsweise in der Datenelementspalte von unten nach oben angewendet hat, so kann wegen der Eineindeutigkeit der logischen Funktion, die für die Bedingung B ≠ W gilt, beim Dekomprimieren die Datenelementspalte mit den ursprünglichen Datenelementen wiederhergestellt werden. Nach Anwendung dieser logischen Funktion auf die Datenelemente aller Datenelementspalten können die Verknüpfungsergebnisse zweier Datenfolgen jeweils erneut seriell vorkomprimiert werden.

In einer weiteren Ausgestaltung des erfindungsgemäßen Verfahrens wird jedes Datenelement einer Datenelementspalte in ein Bewertungs- oder Indikatorcodewort umgeschlüsselt, werden die Indikatorcodeworte der einzelnen Datenelemente einer Datenelementspalte bitweise addiert, unmittelbar benachbarte Indikatorcodeworte bitweise EXKLUSIV-ODER verknüpft, die Verknüpfungsergebnisse ebenfalls addiert und die beiden Additionsergebnisse zur Klassifikation der Datenstruktur ausgewertet. Dabei haben die einzelnen Bitpositionen der Bewertungs- oder Indikatorcodeworte Aussagekraft über den Typ des jeweiligen Datenelementes. So kann beispielsweise eine 1 an der fünften Bitposition eines Bewertungs- oder Indikatorcodewortes bedeuten, daß das erste Halbzeichen des betreffenden Datenelements 0 ist. Durch die bitweise Addition der Indikatorcodeworte der einzelnen Datenelemente einer Datenelementspalte erhält man die Aussage, wieviele Datenelemente in der Datenelementspalte vorhanden sind, deren erstes Halbzeichen 0 ist. Durch die bitweise EXKLUSIV-ODER-Verknüpfung unmittelbar benachbarter Indikatorcodeworte und durch die Addition der Verknüpfungsergebnisse erhält man eine Aussage über die Häufigkeit der Zeichenwechsel zwischen benachbarten Datenelementen. Da die beiden Additionsergebnisse sowohl ein Maß für die Häufigkeit des Auftretens der einzelnen Datenelementtypen als auch ein Maß für die Häufigkeit der Datenelementtypwechsel sind, sind sie als Grundlage für die Auswertung zur Klassifikation der Datenstruktur besonders gut geeignet.

Da die Wahrscheinlichkeit eines halbzeichenweisen Übereinstimmens oder zumindest einer gemeinsamen Charakteristik der Halbzeichen der Datenelemente einer Datenelementspalte größer ist als bei den vollständigen Datenelementen, kann das Komprimierungsergebnis verbessert werden, wenn jede Datenelementspalte halbzeichenweise in eine durch das Klassifikationsergebnis festgelegte Art von Codeworten umgesetzt wird.

Dies geschieht in einfacher Weise dadurch, daß das Klassifikationsergebnis durch m Bits ausgedrückt wird, daß aus dem m Bit-Klassifikationsergebnis zusammen mit einem n Bit-Halbzeichen eine (m + n) Bit-Adresse zur Adressierung eines die Codeworte enthaltenden Codespeichers gebildet wird und daß die adressierten Codeworte nacheinander aus dem Codespeicher ausgelesen werden. Dabei wird durch das m Bit-Klassifikationsergebnis, das den höherwertigen Adreßteil bildet, ein Speicherbereich des Codespeichers ausgewählt, der für die betreffende, durch das Klassifikationsergebnis ausgedrückte Datenstruktur der Datenelementspalte günstige Codeworte für die auftretenden Halbzeichen enthält.

In einer Weiterbildung des Verfahrens werden jeweils die beiden zuletzt aus dem Codespeicher ausgelesenen Codeworte nach jedem Lesezyklus des Codespeichers auf Gleichheit überprüft. Es besteht dadurch die Möglichkeit, aufeinanderfolgende gleiche Codeworte in einem weiteren Verfahrensschritt zusammenzufassen und somit zu komprimieren.

Dies geschieht in einer Weiterbildung der Erfindung dadurch, daß die Anzahl der unmittelbar aufeinanderfolgenden Lesezyklen des Codespeichers, nach denen jeweils die beiden zuletzt aus dem Codespeicher ausgelesenen Codeworte übereinstimmen, gezählt wird. Das Zählergebnis gibt dann an, wie oft der Typ des zuletzt aus dem Codespeicher ausgelesenen Codewortes hintereinander aufgetreten ist.

Eine Weiterbildung des erfindungsgemäßen Verfahrens zeichnet sich dadurch aus, daß das Zählergebnis in Abhängigkeit von der Art der Codeworte derart verschlüsselt wird, daß das verschlüsselte Zählergebnis von den betreffenden Codeworten unterscheidbar ist. Diese Verschlüsselung dient zur sicheren Unterscheidung des Zählergebnisses von den im Codespeicher auftretenden Codeworten.

Bei einer Weiterbildung des erfindungsgemäßen Verfahrens werden das in einer Datenelementspalte überwiegend auftretende Halbzeichen ein einziges Mal und jedes der verbleibenden Halbzeichen sowie ein die jeweilige Stelle dieser verbleibenden Halbzeichen anzeigender Zeiger separat im Komprimierungscode dargestellt. Diese Art der Komprimierung eignet sich besonders gut für weitgehend homogene Datenelementspalten, die nur mit wenigen Störzeichen durchsetzt sind.

Eine Datenverarbeitungseinrichtung zur Durchführung des Verfahrens ist in weiterer Ausbildung des Erfindungsgedankens derart aufgebaut, daß eine Speichermatrix an ihren Adreßeingängen mit einer ersten Umschalteinrichtung versehen ist, mit der in Abhängigkeit von einem ersten Umschaltsignal die Zeilen- und Spaltenadressen der Datenelementspeicherplätze vertauschbar sind. Durch diese Vertauschbarkeit von Zeilen- und Spaltenadressen wird es erst möglich, daß die Speichermatrix sowohl zeilenweise als auch spaltenweise ausgelesen bzw. neu beschrieben werden kann, ohne daß dazu aufwendige Adreßumrechnungen erforderlich sind, die einer hohen Rechnerleistung bedürfen. Da bei den Befehlssätzen üblicher Datenverarbeitungsanlagen die Adressierung einer Speichermatrix nur zeilenweise vorgesehen ist, mußte bisher bei einer spaltenweisen Bearbeitung der Speichermatrix immer zuerst die Adresse des nächstfolgenden Datenelementes in der Datenelementspalte berechnet werden, bevor die gewünschte Rechenoperation ausgeführt werden konnte.

Wenn ferner ein Indexspeicher vorgesehen ist, dessen Zeilenanzahl mit derjenigen der Speichermatrix übereinstimmt und der die Zeilenadressen der Speichermatrix in sortierter Reihenfolge enthält, ist es möglich, auf die Datenelementspeicherplätze einer Datenelementspalte der Speichermatrix entsprechend der Reihenfolge der im Indexspeicher enthaltenen Zeilenadressen sortiert zuzugreifen, ohne daß dazu eine vorangehende aufwendige Umsortierung der Datenelementzeilen der Speichermatrix erforderlich ist. Die Beaufschlagung der Zeilenadreßeingänge der Speichermatrix mit den Ausgangssignalen des Indexspeichers erfolgt vorteilhaft durch eine zweite Umschalteinrichtung, die von einem zweiten Umschaltsignal gesteuert wird.

In einer weiteren Ausbildung ist ein Attribut- und Deskriptorspeicher mit einer dritten Umschalteinrichtung an dessen Adreßeingängen vorgesehen, mit der in Abhängigkeit von einem dritten Umschaltsignal die Zeilen- und Spaltenadressen der Speicherplätze vertauschbar sind. Ein separater Attribut- und Deskriptorspeicher neben der Speichermatrix für die eigentlichen Datenelemente hat den Vorteil, daß bei den Weiterbildungen des erfindungsgemäßen Verfahrens, bei denen eine Sortierung der Datenfolgen vorgenommen wird, diese nicht in ihrer Gesamtheit, sondern lediglich die Inhalte der Zeilen des Attribut- und Deskriptorspeichers in Abhängigkeit von den Sortierkriterien umsortiert werden müssen. In Abhängigkeit von der im Attribut- und Deskriptorspeicher vorgenommenen Umsortierung wird dann der Indexspeicher geladen, so daß die eigentliche Speichermatrix über diesen sortiert adressiert werden kann. Um die Speicherplätze des Attribut- und Deskriptorspeichers sowohl zeilenweise als auch spaltenweise adressieren zu können, ohne rechenzeitaufwendige Adreßumrechnungen vornehmen zu müssen, ist an den Adreßeingängen des Attribut- und Deskriptorspeichers eine dritte Umschalteinrichtung zum Vertauschen der Zeilen- und Spaltenadressen vorgesehen.

Zur Gewinnung des jeweiligen Umschaltsignals aus der Speicheradresse ist vorteilhaft mindestens ein Decoder vorgesehen, der beispielsweise aus der oder den höherwertigen Adreßbits durch Decodierung das jeweilige Umschaltsignal erzeugt.

Gemäß einer Weiterbildung der Erfindung ist als Umschalteinrichtung jeweils ein handelsüblicher Multiplexer vorgesehen.

Die Datenverarbeitungseinrichtung zur Durchführung des Verfahrens kann auch derart aufgebaut sein, daß ein die Indikatorcodeworte enthaltender Lesespeicher vorgesehen ist, der durch die Datenelemente adressierbar ist. Auf diese Weise kann jedem Datenelementtyp ein bestimmtes Indikator- oder Bewertungscodewort auf einfache Weise zugeordnet werden.

In einer Weiterbildung ist dann eine Zähleranordnung mit gegenüber der Bit-Zahl der Indikatorcodeworte doppelter Zahl von Einzelzählern mit dem Datenausgang des Lesespeichers verbunden und sind der Hälfte der Einzelzähler EXKLUSIV-ODER-Glieder vorgeschaltet, deren Eingängen jeweils eine Bitposition von im Lesespeicher unmittelbar benachbarten Indikatorcodeworten zugeführt wird. Durch ein derartiges Indikatorsystem ist es möglich festzustellen, wie oft die Datenelemente einer Datenelementspalte in einer Bitposition übereinstimmen und wieviele Bitwechsel zwischen benachbarten Datenelementen einer Datenelementspalte bei jeder einzelnen Bitposition zu verzeichnen sind. Zur Feststellung der Wechsel bei den einzelnen Bitpostionen sind vorteilhaft zwischen dem Datenausgang des Lesespeichers und den Eingängen der EXKLUSIV-ODER-Glieder zwei Register vorgesehen, welche zur Zwischenspeicherung des jeweils zuletzt bzw. des unmittelbar davor aus dem Lesespeicher ausgelesenen Indikatorcodewortes dienen. Stimmen die Inhalte der beiden Register überein, so bedeutet dies, daß das jeweils letzte und das jeweils vorletzte aus dem Lesespeicher ausgelesene Indikatorcodewort übereinstimmen. An den Ausgängen der EXKLUSIV-ODER-Glieder für die einzelnen Bitpositionen erscheint dann jeweils der Wert 0. Stimmen die Inhalte der beiden Register jedoch in einzelnen Bitpositionen nicht überein, so bedeutet dies, daß bei diesen Bitpositionen zwischen dem jeweils zuletzt und dem unmittelbar davor aus dem Lesespeicher ausgelesenen Indikatorcodewort ein Wechsel stattgefunden hat. An den Ausgängen der EXKLUSIV-ODER-Glieder dieser Bitpositionen erscheint dann jeweils der Wert 1.

Die Datenverarbeitungseinrichtung kann auch derart aufgebaut sein, daß ein Festwertspeicher als Codespeicher vorgesehen ist, der vom Datenstruktur-Klassifikationsergebnis der zu komprimierenden Datenspalte und vom jeweiligen Halbzeichen der betreffenden Datenspalte adressierbar ist, wobei das Datenstruktur-Klassifikationsergebnis den höherwertigen Adreßteil und das jeweilige Halbzeichen den niederwertigen Adreßteil bildet. Auf diese Weise wird durch das Datenstruktur-Klassifikationsergebnis der für die betreffende Datenstruktur relevante Speicherbereich des Codespeichers adressiert, in dem die für die betreffende Datenstruktur günstigen Codeworte für die zu komprimierenden Halbzeichen enthalten sind.

In einer Weiterbildung sind dem Codespeicher ein erstes und ein zweites Register nachgeschaltet, wobei das erste Register das jeweils zuletzt ausgelesene Codewort und das zweite Register das unmittelbar davor ausgelesene Codewort zwischenspeichert. Auf diese Weise kann auf die beiden jeweils zuletzt aus dem Codespeicher ausgelesenen Codeworte jederzeit in einfacher Weise zugegriffen werden.

Vorteilhaft ist in einer weiteren Ausbildung der Datenverarbeitungseinrichtung eine mit den Ausgängen des ersten und des zweiten Registers verbundene Vergleichsschaltung vorgesehen, um mit ihr die Übereinstimmung der beiden jeweils zuletzt aus dem Codespeicher ausgelesenen Codeworte feststellen zu können. Ferner ist ein von der Vergleichsschaltung gesteuerter Zähler vorgesehen, mit dem die Anzahl der unmittelbar aufeinanderfolgenden aus dem Codespeicher ausgelesenen übereinstimmenden Codeworte gezählt werden kann.

Um den auszugebenden Zählerstand des Zählers in Abhängigkeit von der Art der Codeworte in einfacher Weise verschlüsseln zu können, ist vorteilhaft eine die Verschlüsselungscodeworte enthaltende Multiplexerschaltung vorgesehen.

Zur vorstehend beschriebenen logischen Verknüpfung von Datenelementen ist die Datenverarbeitungseinrichtung derart aufgebaut, daß ein A-Register und ein B-Register vorgesehen sind, das auch als Ergebnisregister dient, daß die Ausgänge der beiden Register bitweise mit den Eingängen von EXKLUSIV-ODER-Gliedern verbunden sind und daß die Ausgänge der EXKLUSIV-ODER-Glieder mit den Eingängen eines disjunktiven Verknüpfungsgliedes verbunden sind, dessen Ausgangssignal den Rücksetzeingang des B-Registers steuert. Diese Schaltungsanordnung zeichnet sich durch ihren einfachen Aufbau aus.

Die Erfindung wird im folgenden anhand eines Beispiels einer typischen Datendatei und anhand von Ausführungsbeispielen eines Speichersystems, eines Indikatorsystems, einer Halbzeichenkomprimiereinrichtung und einer Schaltungsanordnung zur logischen Verknüpfung von Datenelementen in einer Datenverarbeitungseinrichtung näher erläutert. Es zeigen:

Fig. 1     eine aus 37 Datensätzen bestehende Datei,

Fig. 2     ein Prinzipschaubild der Ansteuerung einer Speichermatrix über einen Indexspeicher,

Fig. 3     eine schematische Darstellung einer Speichermatrix mit zwei in einer Matrixzeile angeordneten Datenelementen,

Fig. 4     die Speichermatrix von Fig. 3 mit zwei in einer Matrixspalte angeordneten Datenelementen,

Fig. 5     den Schaltplan eines Speichersystems,

Fig. 6     das Adressierschema des Speichersystems von Fig. 5,

Fig. 7     ein Indikatorsystem zur Klassifikation der Datenstruktur einer Datenelementfolge,

Fig. 8     einen Detailausschnitt der in Fig. 7 als Blockschaltbild gezeigten Zähleranordnung,

Fig. 9     eine Halbzeichenkomprimiereinrichtung und

Fig. 10     eine Schaltungsanordnung zur logischen Verknüpfung von Datenelementen.

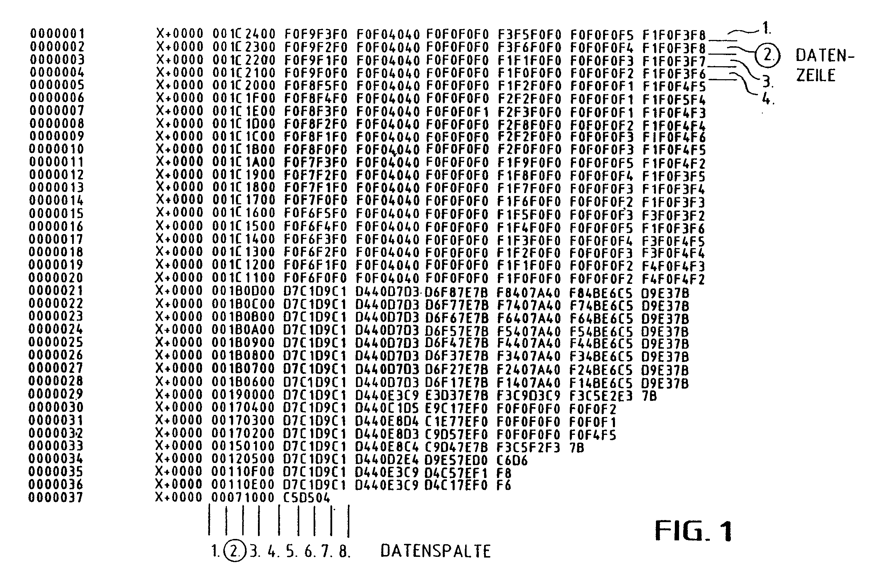

In Fig. 1 ist eine typische, aus hexadezimal dargestellten Datenelementen bestehende Datei gezeigt. Die in ihr enthaltenen 37 Datensätze sind der Länge nach sortiert angeordnet. Anhand dieser Datendatei soll gezeigt werden, daß die einzelnen Datenelemente bei spaltenweiser Betrachtung der Datensätze aufgrund deren Strukturverwandtschaft größere Gemeinsamkeiten untereinander aufweisen, als wenn man sie datensatz- oder zeilenweise betrachtet.

Es sei ferner erwähnt, daß beispielsweise ein Komprimieren von gleichen Zeichen nur dann sinnvoll ist, wenn diese mindestens viermal hintereinander auftreten, da der Komprimierungscode ein eine komprimierte Zeichenfolge anzeigendes Trennzeichen, das komprimierte Zeichen und die Anzahl seines Auftretens enthalten muß.

Betrachtet man beispielsweise in Fig. 1 die zweite Datenzeile, so kann man erkennen, daß das Datenelement F0 als einziges Datenelement einerseits viermal und andererseits fünfmal hintereinander auftritt. Bei einer Komprimierung gleicher Zeichen könnten daher bei dieser Datenzeile lediglich drei Datenelemente eingespart werden, da lediglich die Vierer- und die Fünferdatenelementkette beim Komprimieren jeweils durch drei Zeichen dargestellt werden kann. Betrachtet man dagegen beispielsweise die zweite Datenspalte dieser Datendatei, so kann man erkennen, daß das Datenelement 1C zwanzigmal und das Datenelement 1B achtmal hintereinander auftritt. Bei der spaltenweisen datenelementweisen Komprimierung gleicher Zeichen können hier somit zweiundzwanzig ( = 20 + 8-2x3) Datenelemente eingespart werden. Wenn man sich weitere Datenzeilen bzw. Datenspalten heraussucht und deren Komprimierungsergebnis vergleicht, so zeigt sich, daß eine spaltenweise datenelementweise Komprimierung gegenüber einer zeilenweisen datenelementweisen Komprimierung in der Regel zu einem deutlich besseren Ergebnis führt. Wenn man die spaltenweise Komprimierung der Datenelemente gar halbzeichenweise vornimmt, so kann das Komprimierungsergebnis weiter verbessert werden. Betrachtet man wieder die zweite Datenspalte, so zeigt sich, daß das Halbzeichen oder Halb-Byte "1" insgesamt sechsunddreißigmal hintereinander auftritt. Ein mit einer derartigen Häufigkeit hintereinander auftretendes Halbzeichen kann höchst effektiv komprimiert werden.

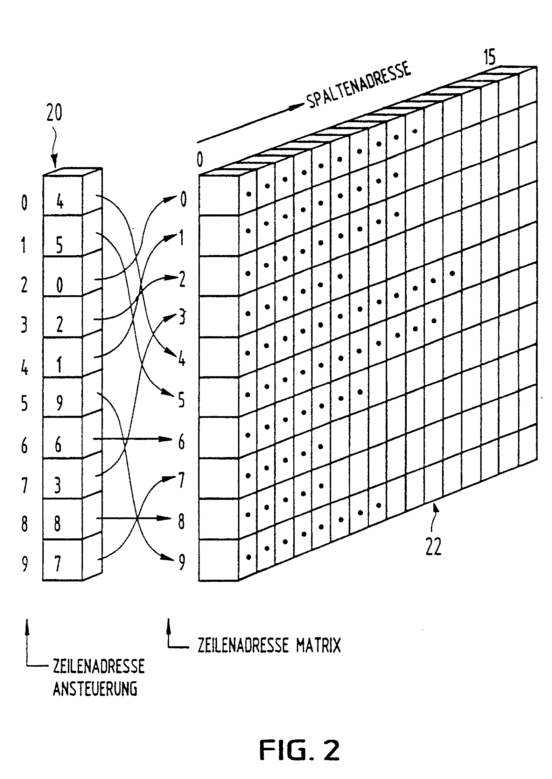

Da die Datensätze einer Datei in dieser in der Regel nicht der Länge nach sortiert angeordnet sind und da es für das spaltenweise Komprimieren der Datenelemente zweckmäßig ist, wenn die einzelnen Datensätze zur Vermeidung von Datenelementlücken mit absteigender Länge von oben nach unten in der Speichermatrix angeordnet sind, ist es erforderlich, entweder die einzelnen die Datensätze enthaltenen Datenzeilen der Speichermatrix umzuordnen oder aber, um Verarbeitungszeit zu sparen, die Speichermatrix sortiert zu adressieren. Dies ist, wie in Fig. 2 schematisch gezeigt, durch eine Zeilenadressierung mittels eines Indexspeichers 20 möglich. Dazu müssen lediglich die im Indexspeicher 20 enthaltenen Zeilenadressen der die einzelnen Datenelemente enthaltenden Speichermatrix 22 so umsortiert werden, daß die Zeile 0 des Indexspeichers 210 die Adresse der Zeile der Speichermatrix 22 enthält, die die größte Anzahl von Datenelementen umfaßt. Die Zeile 1 des Indexspeichers 20 muß dann die Adresse der Zeile der Speichermatrix 22 enthalten, die die zweitgrößte Anzahl von Datenelementen enthält usw. Wird nun der Indexspeicher 20 nacheinander von Zeile 0 bis Zeile 9 sukzessive angesteuert und ausgelesen, so werden über die im Indexspeicher 20 enthaltenen Zeilenadressen der Speichermatrix 22 die einzelnen, die Datensätze enthaltenden Zeilen der Speichermatrix 22 in Abhängigkeit von der Länge der Datensätze sortiert adressiert.

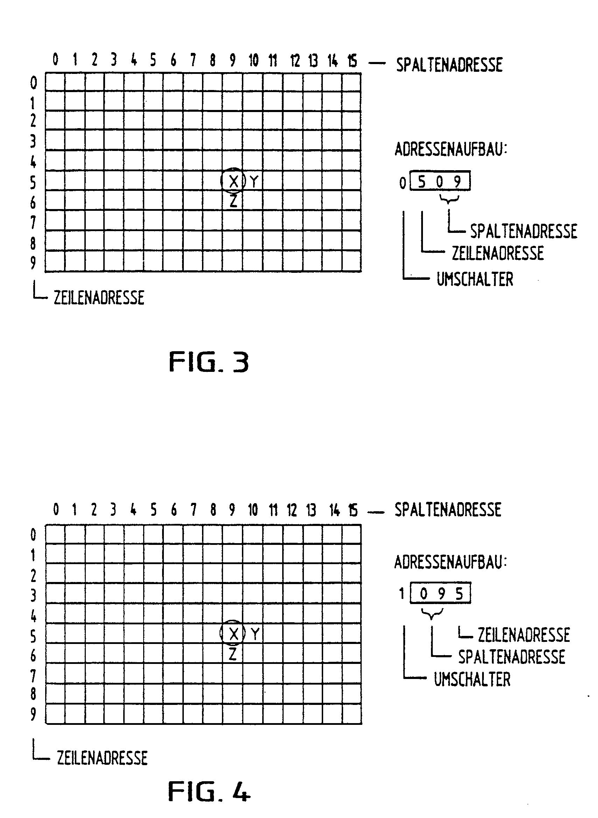

In Fig. 3 ist eine aus 10 Zeilen und 16 Spalten bestehende, mit dezimalen Adressen adressierbare Speichermatrix sowie ihr Adressierschema gezeigt. Wie aus der Fig. 3 zu entnehmen ist, wird das Datenelement X durch die Adresse 509 adressiert, wobei der höherwertige Adreßteil, also die Ziffer 5, die Zeilenadresse ist und der niederwertige Adreßteil, also die Ziffernfolge 09, die Spaltenadresse ist. Die der Adresse 509 vorangestellte Ziffer 0 dient lediglich als Umschalter und wird zur eigentlichen Adressierung des Datenelements X nicht benötigt. Da bei der üblichen sukzessiven Speicheradressierung die Adresse des nächsten Datenelementes lediglich durch Hochzählen der Speicheradresse um 1 erfolgt, wird als nächstes Datenelement das Datenelement Y adressiert, das die selbe Zeilenadresse hat wie das Datenelement X und dessen Spaltenadresse im Vergleich zur Spaltenadresse des Datenelements X einen um 1 höheren Wert hat. Die Tatsache, daß bei der sukzessiven Speicheradressierung nach dem Datenelement X das Datenelement Y in der gleichen Zeile und nicht das Datenelement Z in der gleichen Spalte adressiert wird, ist darauf zurückzuführen, daß üblicherweise die Zeilenadresse den höherwertigen Adreßteil und die Spaltenadresse den niederwertigen Adreßteil bildet, der zunächst hochgezählt wird.

Will man dagegen bei der sukzessiven Speicheradressierung nach dem Datenelement X als nächstes Datenelement Z, also zunächst die Datenelemente einer Spalte adressieren, so ist es erforderlich, daß die Speichermatrix mit einer Adresse adressiert wird, bei der, wie in Fig. 4 gezeigt ist, die Zeilenadresse mit der Spaltenadresse vertauscht ist. Wenn die Spaltenadresse 09 den höherwertigen Adreßteil und die Zeilenadresse 5 den niederwertigen Adreßteil bildet, dann wird beim Hochzählen der Adresse um 1 die Zeilenadresse vom Wert 5 auf den Wert 6 bei gleichbleibender Spaltenadresse hochgezählt, so daß nach dem Datenelement X das Datenelement Z als nächstes Zeichen adressiert wird. Diese Vertauschung der Zeilenadresse mit der Spaltenadresse kann durch eine weitere, für die Adressierung unmittelbar nicht benötigte Adreßstelle, den sogenannten Umschalter, erfolgen. Hat der Umschalter, wie in Fig. 3 gezeigt, beispielsweise den Wert 0, so bedeutet dies, daß die Zeilenadresse mit der Spaltenadresse nicht vertauscht werden soll, mit der Folge, daß beim sukzessiven Speicheradressieren die Speichermatrix zeilenweise adressiert wird. Hat dagegen der Umschalter den Wert 1, wie in Fig. 4 gezeigt, so bedeutet dies, daß die Zeilenadresse mit der Spaltenadresse zur Adressierung der Speichermatrix vertauscht werden soll, mit der Folge, daß beim sukzessiven Adressieren der Speichermatrix diese spaltenweise adressiert wird.

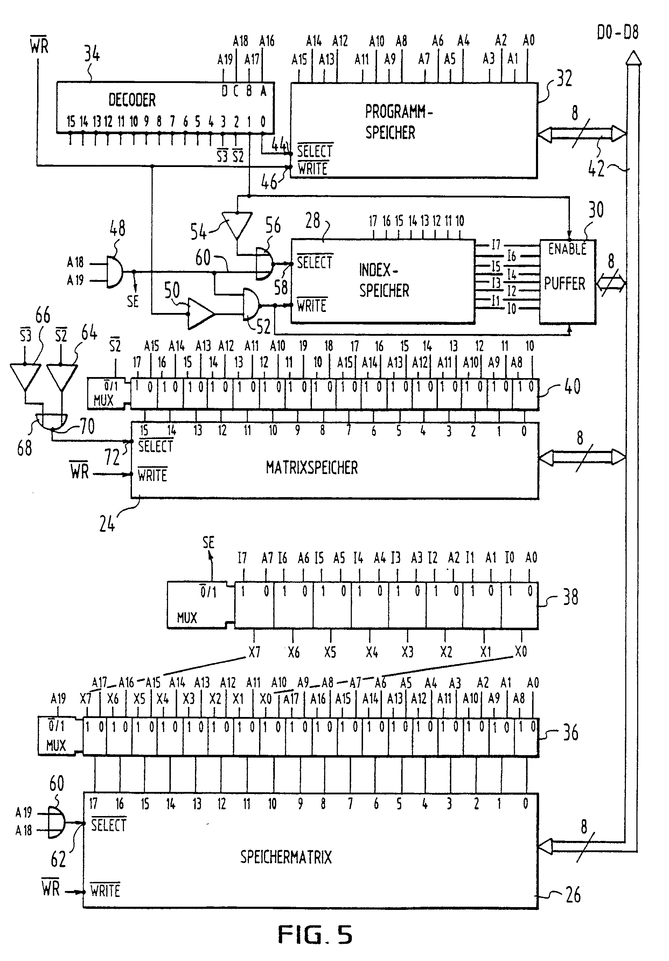

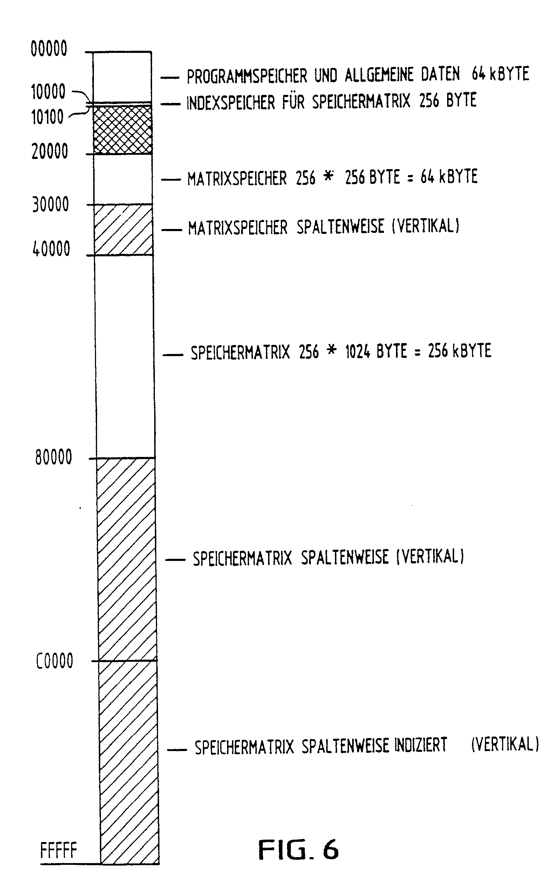

In Fig. 5 ist ein Blockschaltbild eines Speichersystems dargestellt, das sich vorzüglich zur Durchführung des erfindungsgemäßen Verfahrens eignet. Dieses Speichersystem enthält im wesentlichen einen Matrixspeicher 24, eine Speichermatrix 26, einen Indexspeicher 28, verbunden mit einem Datenpuffer 30, einen Programmspeicher 32, einen 1 aus 16 Decoder 34, einen ersten Multiplexer 36, einen zweiten Multiplexer 38 und einen dritten Multiplexer 40. Um den Aufbau und die Funktionsweise dieses Speichersystems verstehen zu können, ist es zunächst erforderlich, die Speicherbelegung dieses Speichersystems anzugeben. Sie soll im folgenden anhand von Fig. 6 in Verbindung mit Fig. 5 erläutert werden.

Der Adressenbereich 00000 bis 0FFFF ist dem 64kByte-Programmspeicher 32 zugeordnet. Der Adreßbereich 10000 bis 100FF dient zur Adressierung der 256 Bytes des Indexspeichers 28. Die Adressen 10100 bis 1FFFF werden bei diesem Speichersystem nicht benutzt. Der Adreßbereich 20000 bis 3FFFF dient zur Adressierung des 64kBytes umfassenden Matrixspeichers 24, wobei dieser über den Adreßbereich 20000 bis 2FFFF zeilenweise und über den Adreßbereich 30000 bis 3FFFF spaltenweise adressierbar ist. Der Speicherbereich 40000 bis FFFFF schließlich ist der Speichermatrix 26 zugeordnet. Die 256kBytes dieser Speichermatrix 26 sind über die Adressen 40000 bis 7FFFF zeilenweise adressierbar. Ferner sind sie über den Adreßbereich 80000 bis BFFFF spaltenweise adressierbar. Über den Adreßbereich C0000 bis FFFFF sind sie darüber hinaus noch spaltenweise indiziert, also sortiert adressierbar. Da bei diesem Speichersystem der Matrixspeicher 24 und die Speichermatrix 26 mehrfach, auf verschiedene Weise adressierbar sind, ist der virtuelle Speicherbereich des Speichersystems deutlich größer als der körperlich vorhandene Speicherbereich. Während letzterer in Fig. 6 unschraffiert dargestellt ist, ist der nur virtuelle Speicherbereich einfach schraffiert gezeigt. Der kreuzweise schraffierte Speicherbereich wird bei diesem Speichersystem nicht benutzt.

Das in Fig. 5 gezeigte Speichersystem hat also einschließlich der Umschalter für die verschiedenen Adressierungsarten einen Adreßbereich von 1 MByte. Dazu sind 20 Bits, also 20 Adreßleitungen A0 bis A19 für die Adreßauswahl erforderlich, um mit einem Schreib- oder Lesezugriff ein Byte als kleinste Speichereinheit adressieren zu können. Die Datenleitungen sind sogenannte bidirektionale Leitungen, d.h. die Information kommt bei Leseoperationen vom Speichersystem, bei Schreiboperationen dagegen wird sie dem Speichersystem auf diesen Leitungen zugeführt. Das Signal $\overline{WR}$ steuert die Speicheroperationen LESEN und SCHREIBEN. Während dieses Signal logisch 0 ist, wenn die Operation SCHREIBEN durchgeführt werden soll, sind die Signale ohne Querstrich logisch 1, wenn sie aktiv sind. Zum Aufbau dieses Speichersystems können handelsübliche Speicherbausteine verwendet werden.

Im folgenden soll die Funktion dieses Speichersystems näher erläutert werden. Die Auswahl des Programmspeichers 32 erfolgt, wenn die Adressen A16 bis A19 logisch 0 sind. Dies wird durch den 1 aus 16 Decoder 34 festgestellt. Seine Ausgänge sind im inaktiven Zustand logisch 1, während sie im aktiven Zustand logisch 0 sind. Wenn also die Adreßbits A16 bis A19, die am Eingang des Decoders 34 anliegen, logisch 0 sind, so erscheint am Ausgang "0" des Decoders 34 das Signal logisch 0, das den $\overline{Select}$-Eingang 44 des Programmspeichers 32 steuert. Da der $\overline{Select}$-Eingang 44 ein negativer Eingang ist, wird der Programmspeicher 32 ausgewählt, wenn dieses Signal logisch 0 ist. Wie bereits vorstehend erwähnt, gilt

für den Eingang $\overline{WRITE}$ 46 das gleiche, d.h. wenn das Signal $\overline{WR}$ logisch 0 ist, wird in diesen Speicherbereich geschrieben. Wenn dieses Signal dagegen logisch 1 ist, wird aus diesem Speicherbereich gelesen und die Informationen auf den Datenbus geschaltet. Da die Speichermatrix 26 (Adreßbereich 40000 bis FFFFF) mit den Adreßbits A18 und A19 eindeutig ausgewählt werden kann, werden beim Decoder 34 die Ausgänge 4 bis 15 nicht genutzt.

Der Indexspeicher 28 wird im Adreßbereich 10000 bis 100FF sowohl im Lese- als auch im Schreibbetrieb, sowie für die indizierte Adressierung der Speichermatrix 26 im Adreßbereich C0000 bis FFFFF nur im Lesebetrieb ausgewählt. Bei letzterem Adreßbereich wird ein Einschreiben in den Indexspeicher 28 durch die logische Verknüpfung des Signals $\overline{WR}$ mit den Adreßsignalen A18 und A19 durch ein UND-Glied 48, einen Invertierer 50 und ein NAND-Glied 52 verhindert. Zur Auswahl des Indexspeichers 28 wird das Signal des Ausgangs "1" des Decoders 34 über einen Invertierer 54 einem NOR-Glied 56 zugeführt, dessen Ausgangssignal den $\overline{Select}$-Eingang 58 des Indexspeichers 28 steuert. Die Auswahl dieses Indexspeichers 28 erfolgt für den Adreßbereich C0000 bis FFFFF nicht durch den Decoder 34, sondern durch die Adreßsignale A18 und A19 unmittelbar.

Diese beiden Signale werden durch das UND-Glied 48 verknüpft, dessen Ausgang mit dem Eingang 60 des NOR-Gliedes 56 verbunden ist. Der Indexspeicher 28 muß eine sehr kurze Zugriffszeit haben, da die Daten dieses Speichers innerhalb eines Speicherzyklus für die Adresse der Speichermatrix 26 benötigt werden.

Da der Indexspeicher 28 nur im Adreßbereich 10000 bis 100FF und nicht auch im Adreßbereich C0000 bis FFFFF beschrieben werden darf, ist der Datenpuffer 30 vorgesehen, der den Informationsfluß von den Datenleitungen 42 zum Indexspeicher 28 nur im Adreßbereich 10000 bis 100FF erlaubt. Die Steuerung dieses Datenpuffers 30 erfolgt durch das am Ausgang 1 des Decoders 34 erscheinende Signal sowie durch das Signal $\overline{WR}$.

Die Speichermatrix 26 besteht aus 256 Zeilen à 1024 Bytes, was einen Speicherbereich von 256 kByte ergibt. Zur Adressierung der 256 Zeilen ist eine Zeilenadresse von 8 Bit Länge und zur Adressierung der 1024 Spalten eine Spaltenadresse von 10 Bit Länge erforderlich. Das ergibt für diese Speichermatrix 26 eine 18 Bit-Adresse. Da diese Speichermatrix 26 für den Adreßbereich 40000 bis 7FFFF zeilenweise und für den Adreßbereich 80000 bis FFFFF spaltenweise bzw. spaltenweise indiziert adressiert wird, kann das höchstwertige Adreßsignal A19 zur Steuerung des ersten Multiplexers 36 verwendet werden. Wenn das Adreßsignal A19 Null ist, so werden die 0-Eingänge des Multiplexers 36 benutzt. In diesem Falle findet keine Vertauschung von Zeilen- und Spaltenadressen statt, so daß der Speicherbereich zeilenweise adressiert wird. Ist das Adreßsignal A19 dagegen 1, so werden die 1-Eingänge des Multiplexers 36 an die Adreßeingänge der Speichermatrix 26 geschaltet, mit der Folge, daß eine Vertauschung von Zeilen- und Spaltenadressen stattfindet. Die Adreßsignale A8 bis A17 werden dann zur Spaltenadresse und die Signale X0 bis X7 zur Zeilenadresse. Die Auswahl dieser Speichermatrix 26 erfolgt, wenn zumindest eines der beiden Adreßsignale A18 und A19 aktiv ist. Sie werden daher durch ein OR-Glied 60, dessen Ausgangssignal den $\overline{\text{Select}}$-Eingang 62 der Speichermatrix 26 steuert, disjunktiv verknüpft.

Die Signale X0 bis X7 stammen vom zweiten Multiplexer 38. Mit diesem kann eine Umschaltung von den Adreßsignalen A0 bis A7 auf die Ausgangssignale I0 bis I7 des Indexspeichers 28 erfolgen. Diese Umschaltung ist erforderlich, wenn die Speichermatrix 26 spaltenweise indiziert adressiert werden soll. Da dies für den Speicherbereich C0000 bis FFFFF erfolgen soll, muß die Umschaltung erfolgen, wenn die beiden höchstwertigen Adreßsignale A19 und A18 gleichzeitig 1 sind, d.h. wenn das Signal SE am Ausgang des UND-Gliedes 48 1 ist.

Da dem Matrixspeicher 24 der Speicherbereich 20000 bis 3FFFF zugeordnet ist, erfolgt die Auswahl dieses Matrixspeichers 24 mit den Signalen $\overline{\text{S2}}$ und $\overline{\text{S3}}$ des Decoders 34. Diese Signale werden durch Invertierer 64 bzw. 66 invertiert und anschließend durch ein NOR-Glied 68 verknüpft, dessen Ausgang 70 mit dem $\overline{\text{Select}}$-Eingang 72 des Matrixspeichers 24 verbunden ist. Dieser umfaßt einen Speicherbereich von 256x256 Byte = 64kByte. Zu seiner Adressierung ist daher nur eine 16 Bit-Adresse, bestehend aus einer 8 Bit-Zeilen- und einer 8 Bit-Spaltenadresse, erforderlich. Diese 16 Bit-Adresse wird dem Matrixspeicher 24 vom dritten Multiplexer 40 zugeführt. Die Steuerung dieses Multiplexers 40 erfolgt durch das Signal $\overline{\text{S2}}$ vom Decoder 34. Ist dieses Signal logisch 0, so werden die 0-Eingänge des Multiplexers 40 für die Bildung der 16 Bit-Adresse des Matrixspeichers 24 verwendet. Diese 0-Eingänge sind mit den Adreßbits A0 bis A15 in aufsteigender normaler Adreßreihenfolge beaufschlagt. Bei den 1-Eingängen des Multiplexers 40 sind die Spalten- und Zeilenadreßbits des Matrixspeichers 24 vertauscht angeordnet. Die Adresse A8 bis A15 ist in diesem Falle die Spaltenadresse, während die Adresse A0 bis A7 die Zeilenadresse darstellt. Durch diese Adreßumschaltung durch den Multiplexer 40 kann der Matrixspeicher 24, der bei der Durchführung des vorstehend beschriebenen Verfahrens als Attribut- und Deskriptorspeicher dient, sowohl zeilenweise als auch spaltenweise adressiert werden.

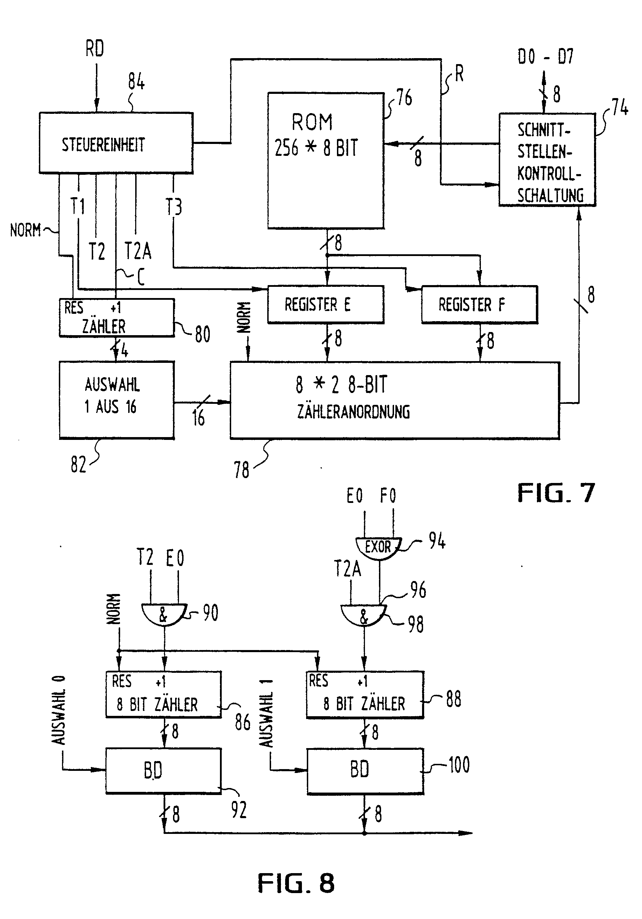

Fig. 7 zeigt ein Indikatorsystem zur Klassifikation der Datenstruktur einer Datenelementreihe. Es besteht aus einer Schnittstellenkontrollschaltung 74, die den bidirektionalen Datenverkehr regelt, einem NUR-Lesespeicher 76, dem ein Register E und ein Register F nachgeschaltet sind, einer mit den Ausgängen dieser Register verbundenen Zähleranordnung 78, welche (8x2) 8 Bit-Einzelzähler umfaßt, einer von einem weiteren Zähler 80 mit 4 Bit-Ausgang gesteuerten 1 aus 16 Auswahlschaltung 82 und einer Steuereinheit 84 zur Steuerung dieser Komponenten.

Nachdem vorstehend der Aufbau dieses Indikatorsystems beschrieben wurde, wird im folgenden seine Funktionsweise anhand von Fig. 7 in Verbindung mit Fig. 8 näher erläutert. Zunächst werden die Datenelemente z.B. einer Datenelementspalte der Schnittstellenkontrollschaltung 74 zugeführt. Die durch das Signal RD aktivierte Steuereinheit 84 gibt ein Übernahmesignal R an die Schnittstellenkontrollschaltung 74 ab, wodurch die Übernahme der Datenelemente bewirkt wird. Diese dienen zur Adressierung des einspaltigen, aus 256 Zeilen bestehenden, die Indikatorcodeworte enthaltenden NUR-Lesespeichers 76. Zu Beginn des ersten Zyklus zur Übernahme des ersten Indikatorcodewortes in die Register E bzw. F werden sämtliche Zähler durch das Signal NORM rückgesetzt. Während jeweils eines Zyklus wird ein einem Datenelement entsprechendes Indikatorcodewort zunächst mit dem Takt T1 in das Register E übernommen. Mit dem Takt T3, der mit zeitlichem Abstand auf den Takt T1 folgt, wird dasselbe Indikatorcodewort in das Register F übernommen. Wie aus Fig. 8 zu entnehmen ist, die eine 2x8 Bit-Zählerkombination der Zähleranordnung 78 von Fig. 7 im Detail zeigt, sind für jedes Bit der Register E und F zwei 8 Bit-Zähler vorgesehen. Dabei zählt beispielsweise der Zähler 86 wie oft das Bit 0 des Registers E logisch 1 ist und der Zähler 88 zählt die Wechsel von 0 nach 1 oder umgekehrt. Beim Zähler 86 wird dies dadurch realisiert, daß dem Zählereingang ein UND-Glied 90 vorgeschaltet ist, an dessen Eingängen das Signal E0 des Registers E und der Takt T2, der zeitlich zwischen dem Takt T1 und dem Takt T3 liegt, anliegen. Hat also das Bit E0 des Registers E den Wert 1, so wird der Zähler 86 mit dem Takt T2 um 1 erhöht.

Die Wechsel von 0 nach 1 oder umgekehrt werden beispielsweise bei der Bitposition 0 dadurch festgestellt, daß die Signale E0 und F0 der Register E und F einem EXKLUSIV-ODER-Glied 94 zugeführt werden, dessen Ausgang mit dem einen Eingang 96 eines UND-Gliedes 98 verbunden ist. Das Ausgangssignal dieses UND-Gliedes 98 steuert den Zähler 88. Stimmen die Signale E0 und F0 nicht überein, so ist das Ausgangssignal des EXKLUSIV-ODER-Gliedes 94 logisch 1. In diesem Falle wird bei Auftreten des Taktes T2A der Zähler 88 um 1 erhöht. Da ein am Ausgang des NUR-Lesespeichers 76 vorliegendes Indikatorcodewort beim Takt T1 in das Register E und erst beim Auftreten des Taktes T3 in das Register F übernommen wird, ist zum Zeitpunkt T2A, der zwischen dem Zeitpunkt T1 und T3 liegt, das am Ausgang des NUR-Lesespeichers 76 vorhandene Indikatorcodewort nur im Register E gespeichert, während im Register F noch das Indikatorcodewort enthalten ist, das beim unmittelbar vorausgehenden Zyklus aus dem NUR-Lesespeicher 76 ausgelesen wurde. Auf diese Weise kann mit dem Zähler 88 festgestellt werden, wie oft benachbarte Indikatorcodeworte einer Datenfolge bei der Bitposition 0 voneinander abweichen. Wichtig ist bei dieser Zähleranordnung, daß der Takt T2A im ersten Taktzyklus unterdrückt wird, da sonst die Anzahl der Bitwechsel falsch gezählt wird.

Nach der Übernahme sämtlicher Datenelemente einer Datenelementreihe durch die Schnittstellenkontrollschaltung 74 werden von der 1 aus 16-Auswahlschaltung 82 nacheinander die Signale AUSWAHL 0 bis AUSWAHL 16 erzeugt, wobei die Signale AUSWAHL 0 und AUSWAHL 1 die beiden Leitungstreiber 92 und 100 steuern. Zuerst wird der Zählerstand des Zählers 86 über den Leitungstreiber 92 und über die Schnittstellenkontrollschaltung 74 auf den Datenbus gegeben. Nach jeder Zählerstandausgabe wird der Zähler 80 durch ein von der Steuereinheit 84 erzeugtes Signal C um 1 hochgezählt. Der um 1 erhöhte Zählerstand des Zählers 80 dient zur Auswahl des nächsten Einzelzählers der Zähleranordnung 78.

Da für jedes Bit der Indikatorcodeworte zwei in Fig. 8 gezeigte Einzelzähler vorhanden sind, kann für jede Bitposition der Indikatorcodeworte einer Datenfolge festgestellt werden, wie oft die entsprechende Bitposition 1 ist bzw. wie oft Wechsel von 0 nach 1 oder umgekehrt stattfinden. Insgesamt sind also 8x2 = 16 8 Bit-Einzelzähler vorgesehen. Die Auswertung der Zählergebnisse kann beispielsweise per Software erfolgen.

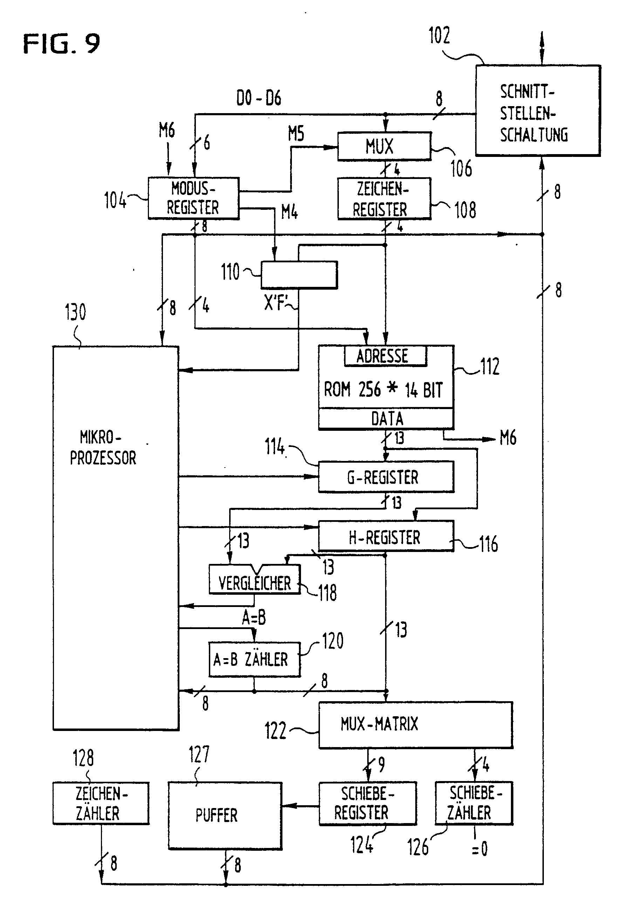

In Fig. 9 ist das Blockschaltbild einer Halbzeichenkomprimiereinrichtung für Datenworte von 8 Bit Länge gezeigt. Sie umfaßt eine Schnittstellenschaltung 102, durch die der Datentransfer und die Datenkontrolle vorgenommen wird. Ihr sind ein MODUS-Register 104 einerseits und ein Multiplexer 106 mit nachfolgendem Zeichenregister 108 andererseits nachgeschaltet. Die Ausgänge des Zeichenregisters 108 sind mit den Eingängen einer Erkennungsschaltung 110 für ein Füllzeichen, beispielsweise X'F', verbunden. Sie sind ferner mit dem niederwertigen Teil der Adreßeingänge eines Festwertspeichers 112, kurz ROM genannt, verbunden. Die höherwertigen Adreßeingänge dieses ROM 112 sind mit den vier niederwertigen Ausgängen des MODUS-Registers 104 verbunden. Insgesamt ist der ROM 112 mit einer 8 Bit-Adresse adressierbar und umfaßt daher maximal 256 Zeilen. Für jede Adresse sind 14 Bits im ROM 112 gespeichert. Während maximal 9 Bits für die Darstellung des Zeichens selbst vorgesehen sind, ist in weiteren 4 Bits die Anzahl der gültigen linksbündigen Zeichenbits codiert. Ein Bit ist für den Fehlerfall vorgesehen. Es setzt dann das Bit M6 des MODUS-Registers 104. Die übrigen Ausgänge des ROM 112, die 13 Bits umfassen, sind mit einem G-Register 114 und mit einem H-Register 116 verbunden, wobei das G-Register 114 die gerade am Ausgang des ROM 112 vorliegenden Daten und das H-Register 116 die Daten enthält, die zuletzt aus dem ROM 112 ausgelesen wurden. Die Ausgänge beider Register 114 und 116 sind mit einem 13 Bit-Vergleicher 118 verbunden. Es ist ferner ein Zähler 120 vorgesehen, der in Abhängigkeit vom Vergleichsergebnis des Vergleichers 118 hochgezählt wird. Die Ausgänge dieses Zählers 120 sind ebenso wie die Ausgänge des H-Registers 116 mit den Eingängen einer 13 Bit-Multiplexerschaltung 122 verbunden. Dieser sind ein 9 Bit-Schieberegister 124 sowie ein Schiebezähler 126 nachgeschaltet. Der serielle Ausgang des Schieberegisters 124 ist mit dem Eingang eines Pufferspeichers 127 verbunden. Es ist ferner ein Zeichenzähler 128 vorgesehen, der bei der Übernahme von jeweils 8 Bits vom Schieberegister 124 in den Pufferspeicher 127 um 1 hochgezählt wird. Das funktionsgerechte Zusammenwirken der vorstehend genannten Komponenten der Halbzeichenkomprimiereinrichtung wird durch einen Mikroprozessor 130 gesteuert.

Im folgenden soll die Funktionsweise dieser Halbzeichenkomprimiereinrichtung näher erläutert werden. Soll eine Folge von 8 Bit-Datenworten, beispielsweise eine Datenelementspalte einer Speichermatrix komprimiert werden, so wird zunächst das vom vorstehend beschriebenen Indikatorsystem für die betreffende Datenspalte erzeugte Klassifikationsergebnis von der Schnittstellenschaltung 102 übernommen und in das MODUS-Register 104 eingeschrieben. Dieses MODUS-Register 104 umfaßt 8 Bits, wovon 6 Bits durch die Signale D0 bis D5 geladen werden. Die restlichen Bits sind Fehleranzeigen. Dabei dienen die Bits M0 bis M3 zur Speicherung des vom Indikatorsystem erhaltenen Klassifikationsergebnisses, durch das die Art des Komprimierens festgelegt wird. Das Bit M4 gibt an, ob ein Füllzeichen, in diesem Falle das Halbzeichen X'F' unterdrückt werden soll. Das Bit M5 dient zur Umschaltung der Datenauswahl, d.h. durch das Bit M5 wird festgelegt, ob bei den anschließend zu übernehmenden Datenworten die Bits D0 bis D3 oder D4 bis D7 als zu komprimierende Halbzeichen herangezogen werden sollen. Das Bit M6 dient zur Fehleranzeige und wird vom ROM 112 übernommen. Es zeigt an, wenn Daten nicht korrekt komprimiert werden konnten. Das Bit M7 bleibt frei.

Nach dem Laden des MODUS-Registers werden die Datenworte der zu komprimierenden Datenelementspalte nacheinander von der Schnittstellenschaltung 102 übernommen und dem Multiplexer 106 zugeführt. Von diesem werden in Abhängigkeit vom MODUS-Register-Bit M5 entweder die Datenbits D0 bis D3 oder die Datenbits D4 bis D7 ausgewählt und dem Zeichenregister 108 zugeführt. Anschließend werden die vom Zeichenregister 108 übernommenen Datenbits durch die Erkennungsschaltung 110 für das Füllzeichen, in diesem Falle für das Halbzeichen X'F', überprüft. In Abhängigkeit vom MODUS-Register-Bit M4 wird dann das übernommene 4 Bit Halbzeichen unterdrückt, wenn es mit dem Halbzeichen X'F' übereinstimmt. Anschließend wird der ROM 112 durch die Bits M0 bis M3 des MODUS-Registers 104 als höherwertiger Adreßteil und mit dem übernommenen Halbzeichen als niederwertiger Adreßteil vom Zeichenregister 108 adressiert. Dabei geben die 4 Bits M0 bis M3 an, auf welche Weise das jeweilige Halbzeichen konvertiert werden soll. Da aufgrund der 4 Bit Länge der Halbzeichen nur maximal 16 verschiedene Halbzeichen auftreten können, sind für jede durch die höherwertigen 4 Bits der ROM-Adresse festgelegte Komprimierungsart 16 Zeilen im ROM 112 vorgesehen, in denen die Komprimierungscodeworte der Halbzeichen für die betreffende Komprimierungsart enthalten sind. Neben den maximal 9 Bits für die Darstellung der Halbzeichen sind im ROM 112 in jeder Zeile jeweils weitere 4 Bits vorgesehen, die die Anzahl der gültigen linksbündigen Codewortbits wiedergeben. Das 14. Bit ist, wie bereits vorstehend erwähnt, für den Fehlerfall vorgesehen und setzt das MODUS-Register-Bit M6. Das G-Register 114 und das H-Register 116 werden vom ROM 112 derart geladen, daß das G-Register 114 jeweils den zuletzt ausgelesenen Wert des ROM 112 und das H-Register 116 den unmittelbar davor ausgelesenen Wert enthält. Durch den Vergleicher 118 werden die beiden Register 114 und 116 nach jeder Codewortübernahme miteinander verglichen. Mit dem Zähler 120 wird gezählt, wie oft die beiden Register 114 und 116 nach Übernahme eines neuen Codewortes unmittelbar hintereinander übereinstimmen. Mit Hilfe der Multiplexerschaltung 122 wird entweder der Inhalt des H-Registers 116 oder der Zählerstand des Zählers 120 an das Schieberegister 124 und an den Schiebezähler 126 ausgegeben. Die Steuerung der Multiplexerschaltung 122 wird dabei durch den Mikroprozessor 130 vorgenommen. Stimmen die Register 114 und 116 mehrfach hintereinander nicht überein, so wird der Inhalt des H-Registers 116 jeweils dem Schieberegister 124 und dem Schiebezähler 126 zugeführt. Dabei erhält das Schieberegister 124 die maximal 9 Bits des Komprimierungscodewortes und der schiebezähler 126 das Codewort für die Anzahl der gültigen linksbündigen Codewortbits des Schieberegisters 124. Stimmen dagegen die Register 114 und 116 beispielsweise n mal hintereinander überein, so wird zunächst der Inhalt des H-Registers 116 mit Hilfe dar Multiplexerschaltung 122 an das Schieberegister 124 bzw. an den Schiebezähler 126 ausgegeben. Anschließend wird, gesteuert durch den Mikroprozessor 130, das Zählergebnis des Zählers 120 der Multiplexerschaltung 122 zugeführt und durch diese in Abhängigkeit von der durch das Klassifikationsergebnis des Indikatorsystems festgelegten Art der Komprimierung umcodiert und in dieser Form an das schieberegister 124 und an den Schiebezähler 126 ausgegeben. Auch in diesem Falle enthält der Schiebezähler 126 die Anzahl der gültigen linksbündigen Bits des Schieberegisters 124. Diese werden, gesteuert durch den Schiebezähler 126, an den Pufferspeicher 127 ausgegeben. Die von diesem übernommenen Bits werden gezählt. Bei der Übernahme von je 8 Bits wird der Zeichenzähler 128 jeweils um 1 erhöht. Nach der Komprimierung sämtlicher Datenelemente der Datenelementspalte wird der Pufferspeicher 127 solange mit Nullen aufgefüllt, bis die gespeicherte Bitanzahl ein ganzzahliges Vielfaches von 8 Bits ist. Anschließend wird der Inhalt des Pufferspeichers 127, der nun die Datenelemente der Datenelementspalte als Komprimierungscodeworte enthält, der Schnittstellenschaltung 102 zugeführt und dann ausgegeben.

Die Auswahlsignale des gesamten aus zwei Halbzeichenkomprimiereinrichtungen bestehenden Komprimierers sind derart festgelegt, daß die beiden Halbzeichenkomprimiereinrichtungen 4-bitweise parallel arbeiten können, die Moduseinstellung und das Auslesen der Ergebnisse jedoch getrennt erfolgen kann.

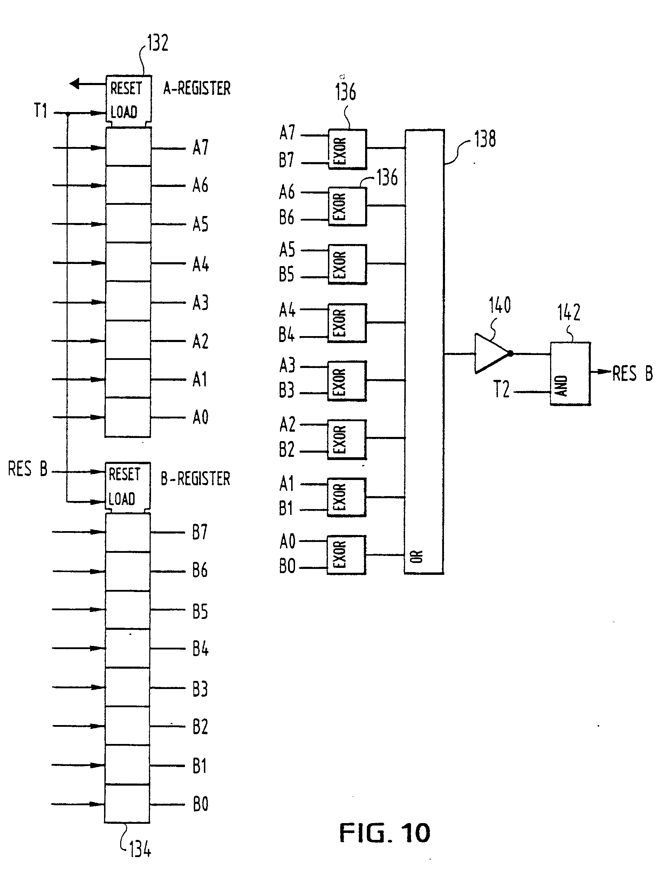

In Fig. 10 ist eine Schaltungsanordnung zur logischen Verknüpfung von Datenelementen gemäß folgender Wahrheitstabelle gezeigt:

$A \times B = 0$ falls $A = B$
$A \times B = B$ falls $A \neq B$

unter der Bedingung $B \neq 0$, mit 0 als Wiederholungszeichen.

Diese Schaltungsanordnung besteht aus einem A-Register 132, aus einem B-Register 134, aus 8 EXKLUSIV-ODER-Gliedern 136, durch die das A-Register 132 und das B-Register 134 bitweise miteinander verknüpft werden, aus einem ODER-Glied 138, das die Ausgänge der 8 EXKLUSIV-ODER-Glieder 136 disjunktiv verknüpft, und aus einem Invertierer 140, über den das Ausgangssignal des ODER-Gliedes 138 einem Eingang eines UND-Gliedes 142 zugeführt wird. Der zweite Eingang des UND-Gliedes 142 wird mit dem Takt T2 beaufschlagt. Durch das Ausgangssignal RES B des UND-Gliedes 142 kann das B-Register 134 rückgesetzt werden.

Sollen zwei 8 Bit Datenelemente A und B gemäß obiger Funktion logisch verknüpft werden, so werden sie mit dem Takt T1 in das A-REgister 132 bzw. in das B-Register 134 geladen. Durch die bitweise EXKLUSIV-ODER-Verknüpfung der Inhalte der beiden Register 132 und 134 erhält man an den Ausgängen derjenigen EXKLUSIV-ODER-Glieder 136 ein Signal logisch 0, deren Eingänge übereinstimmen. Stimmen die Inhalte der beiden Register 132 und 134 in allen Bitpositionen überein, so erscheint an sämtlichen Ausgängen der EXKLUSIV-ODER-Glieder 136 das Signal logisch 0, so daß am Ausgang des ODER-Gliedes 138 ebenfalls das Signal logisch 0 und am Ausgang des Invertierers 140 folglich das Signal logisch 1 anliegt. Die UND-Verknüpfung des logisch 1 Signales am Ausgang des Invertierers 140 mit dem Taktsignal T2 durch das UND-Glied 142 bewirkt, daß an dessen Ausgang bei einem Takt T2 = logisch 1 das Signal RES B = logisch 1 auftritt, das das B-Register 134 rücksetzt, so daß dieses an allen Bitpositionen Nullen enthält.

Ist dagegen das Ausgangssignal wenigstens eines der 8 EXKLUSIV-ODER-Glieder 136 logisch 1, was dann der Fall ist, wenn die Inhalte der beiden Register 132 und 134 zumindest an einer Bitposition nicht übereinstimmen, so erscheint am Ausgang des ODER-Gliedes 138 das Signal logisch 1, welches nach Invertierung durch den Invertierer 140 dem UND-Glied 142 zugeführt wird. In diesem Falle bleibt der Signalpegel logisch 0 am Ausgang des UND-Gliedes 142 bei Auftreten des Taktsignals T2 = logisch 1 erhalten, mit der Folge, daß das B-Register 134 nicht rückgesetzt wird und seinen Inhalt beibehält.

**Patentansprüche**

1. Verfahren zum Komprimieren und Dekomprimieren mehrerer strukturverwandter aus Datenelementen bestehender Datenfolgen, insbesondere Datensätze, bei dem die zu komprimierenden strukturverwandten Datenfolgen in einer Speichermatrix (26) parallel gespeichert werden, zur Gewinnung einer eine Anzahl von Datenelementen der Datenfolgen verbindenden Charakteristik für mehrere Datenfolgen eine Strukturanalyse von Datenelementen übereinstimmender, die Position eines Datenelementes innerhalb der Datenfolge kennzeichnender Ordnungszahl vorgenommen wird, anstelle dieser Datenelemente beim Komprimieren ein Code verwendet wird und beim Dekomprimieren die durch Decodieren des Codes gewonnenen Datenelemente in Datenfolgen unter Berücksichtigung der jeweils betreffenden Ordnungszahl geordnet werden, dadurch **gekennzeichnet,** daß vor der Strukturanalyse die gespeicherten Datenfolgen auf ihre Länge untersucht, mit Datenfolgen gleicher Länge Datenfolgengruppen gebildet und die Datenfolgengruppen nach zunehmender oder abnehmender Länge geordnet werden.

2. Verfahren nach Anspruch 1, dadurch **gekennzeichnet,** daß geordnete Datenfolgen gleicher effektiver Länge auf übereinstimmende Datenfolgecharakteristik untersucht und entsprechend geordnet werden, daß bei geordneten Datenfolgen gleicher effektiver Länge und gleicher Charakteristik die Speichermatrix-Zeilennummer festgestellt wird und daß diese Datenfolgen nach zunehmender oder abnehmender Speichermatrix-Zeilennummer geordnet werden.

3. Verfahren nach einem der vorhergehenden Ansprüche, dadurch **gekennzeichnet,** daß jede Datenfolge durch ein mindestens die effektive Datenfolgelänge, mindestens eine Datenfolgecharakteristik und die Speichermatrix-Zeilennummer enthaltendes Attributfeld (24) ergänzt wird, daß das jeweils letzte Datenelement mindestens einer Datenfolge sowie ggf. die Zahl solcher Datenelemente (Wiederholungsfaktor) in das Attributfeld (24) übernommen wird und daß dieses letzte Datenelement sowie seine mit ihm übereinstimmenden unmittelbaren Vorgänger zur Verkürzung in der Datenfolge eliminiert werden.

4. Verfahren nach einem der vorhergehenden Ansprüche, dadurch **gekennzeichnet,** daß mindestens die längste aus gleichen Datenelementen, insbesondere Störzeichen, bestehende Zeichenkette einer Datenfolge bzw. Datenelementspalte eliminiert und durch Füllzeichen (X'F') ersetzt wird und daß diese Zeichenkette in einem für jede Datenfolge separat vorgesehenen Deskriptorfeld (24) durch einen den Zeichenkettenanfang markierenden Zeiger, durch die Zeichenkettenlänge und durch das ersetzte Zeichen beschrieben wird.

5. Verfahren nach einem der vorhergehenden Ansprüche, dadurch **gekennzeichnet,** daß für jede Datenelementspalte jeweils mindestens ein Spaltendeskriptorfeld (24) vorgesehen wird, das die Datenelementspalte zumindest teilweise beschreibt und daß aus gleichen Zeichen bestehende Datenelementspalten eliminiert, durch Füllzeichen (X'F') ersetzt und in den betreffenden Deskriptorfeldern (24) durch Angabe des jeweils ersetzten Zeichens beschrieben werden.

6. Verfahren nach Anspruch 5, dadurch **gekennzeichnet,** daß zumindest die längste aus gleichen Datenelementen bestehende Zeichenkette einer Datenelementspalte in ein im Vergleich zur betreffenden Zeichenkette kürzeres Codewort umcodiert und durch dieses ersetzt wird und daß die dabei freiwerdenden Datenelementplätze mit Füllzeichen (X'F') aufgefüllt werden.

7. Verfahren nach Anspruch 5 oder 6, dadurch **gekennzeichnet,** daß die Datenelemente einer Datenelementspalte durch die logische Funktion mit der Wahrheitstabelle

A x B = W, falls A = B und
A x B = B, falls A ≠ B

unter der Bedingung B ≠ W, wobei W ein beliebiges Wiederholungszeichen ist, verknüpft werden.

8. Verfahren nach einem der vorhergehenden Ansprüche, dadurch **gekennzeichnet,** daß jedes Datenelement einer Datenelementspalte in ein Bewertungs- oder Indikatorcodewort umgeschlüsselt wird, daß die Indikatorcodeworte der einzelnen Datenelemente einer Datenelementspalte bitweise addiert werden, daß unmittelbar benachbarte Indikatorcodeworte bitweise EXKLUSIV-ODER-verknüpft werden (136), daß die Verknüpfungsergebnisse addiert werden und daß die beiden Additionsergebnisse zur Klassifikation der Datenstruktur ausgewertet werden, wobei vorzugsweise die jeweilige Datenelementspalte halbzeichenweise in eine durch das Klassifikationsergebnis festgelegte Art von Codeworten umgesetzt wird.

9. Datenverarbeitungseinrichtung zur Durchführung des Verfahrens nach einem der vorhergehenden Ansprüche, dadurch **gekennzeichnet,** daß eine Speichermatrix (26) an ihren Adreßeingängen mit einer ersten Umschalteinrichtung (36) versehen ist, mit der in Abhängigkeit von einem ersten Umschaltsignal die Zeilen- und Spaltenadressen der Datenelementspeicherplätze vertauschbar sind und daß ein Indexspeicher (28) vorgesehen ist, dessen Zeilenanzahl mit derjenigen der Speichermatrix (26) übereinstimmt und der die Zeilenadressen der Speichermatrix (26) in sortierter Reihenfolge enthält.

10. Datenverarbeitungseinrichtung nach Anspruch 9, dadurch **gekennzeichnet,** daß eine zweite Umschalteinrichtung (38) vorgesehen ist, mit der die Zeilenadreßeingänge der Speichermatrix (26) in Abhängigkeit von einem zweiten Umschaltsignal mit den Ausgängen des Indexspeichers (28) beaufschlagbar sind.

11. Datenverarbeitungseinrichtung nach Anspruch 9 oder 10, dadurch **gekennzeichnet,** daß ein Attribut-und Deskriptorspeicher (24) an seinen Adreßeingängen mit einer dritten Umschalteinrichtung (40) verbunden ist, mit der in Abhängigkeit von einem dritten Umschaltsignal die Zeilen- und Spaltenadressen der Speicherplätze vertauschbar sind.

12. Datenverarbeitungseinrichtung zur Durchführung des Verfahrens nach Anspruch 8, dadurch **gekennzeichnet,** daß ein die Indikatorcodeworte enthaltender Lesespeicher (76) vorgesehen ist, der durch die Datenelemente adressierbar ist, daß eine Zähleranordnung (78) mit gegenüber der Bit-Zahl der Indikatorcodeworte doppelten Zahl von Einzelzählern (86, 88) mit dem Datenausgang des Lesespeichers (76) verbunden ist und daß der Hälfte der Einzelzähler (86, 88) EXKLUSIV-ODER-Glieder (94) vorgeschaltet sind, deren Eingängen jeweils eine Bitposition von im Lesespeicher (76) unmittelbar benachbarten Indikatorcodeworten zugeführt ist.

13. Datenverarbeitungseinrichtung zur Durchführung des Verfahrens nach Anspruch 8, dadurch **gekennzeichnet,** daß ein Festwertspeicher (112) als Codespeicher vorgesehen ist, der vom Datenstruktur-Klassifikationsergebnis der zu komprimierenden Datenspalte und vom jeweiligen Halbzeichen der betreffenden Datenspalte adressierbar ist, wobei das Datenstrukturklassifikationsergebnis den höherwertigen Adreßteil und das jeweilige Halbzeichen den niederwertigen Adreßteil bildet.

14. Datenverarbeitungseinrichtung nach Anspruch 13, dadurch **gekennzeichnet,** daß eine Vergleichsschaltung (118) mit den Ausgängen des ersten (114) und des zweiten Registers (116) verbunden ist, die einen Zähler (120) steuert, und daß zum von der Art der Codeworte abhängigen Verschlüsseln des auszugebenden Zählerstandes des Zählers (120) eine die Verschlüsselungscodeworte enthaltende Multiplexerschaltung (122) vorgesehen ist.

15. Datenverarbeitungseinrichtung zur Durchführung des Verfahrens nach einem der Ansprüche 7 oder 8, dadurch **gekennzeichnet,** daß ein A-Register (132) und ein B-Register (134) vorgesehen sind, das auch als Ergebnisregister dient, daß die Ausgänge der beiden Register (132, 134) bitweise mit den Eingängen von EXKLUSIV-ODER-Gliedern (136) verbunden sind und daß die Ausgänge der EXKLUSIV-ODER-Glieder (136) mit den Eingängen eines disjunktiven Verknüpfungsgliedes (138) verbunden sind, dessen Ausgangssignal den Rücksetzeingang des B-Registers (134) steuert.

## Claims

1. A process for compressing and expanding structurally-associated multiple data sequences consisting of data elements, in particular data sets in which the structurally-associated data sequences to be compressed are stored in parallel in a storage matrix (26), for obtaining a characteristic common to a number of data elements of the data sequences for a multiple data sequences a structural analysis is made of data elements with equal order number characterizing the position of a data element within the data sequence; in place of these data elements, a code is used during compressing; and the data elements obtained by decoding the code are ordered in data sequences on the basis of their respective order number during expansion, **characterized** in that previous to the structural analysis, the data sequences stored are examined for their length, that data sequence groups are formed out of data sequences of equal length, and that the data sequence groups are ordered according to their increasing or decreasing length.

2. Process according to claim 1, **characterized** in that the ordered data sequences of equal effective length are examined for common data sequence characteristics and are ordered correspondingly, that the storage matrix-line number is determined for ordered data sequences of equal effective length and the same characteristics, and that these data sequences are ordered in accordance with increasing or decreasing storage matrix-line number.

3. Process according to anyone of the foregoing claims, **characterized** in that each data sequence is supplemented by an attribute field (24) containing at least the effective length of the data sequence, at least one data sequence characteristic and the storage matrix-line number, that the respective last data element of at least one data sequence and, if necessary, the number of such data elements (repetition factor) is taken over into the attribute field (24) and that this last data element as well as its corresponding direct precursor are eliminated for shortening the data sequence.

4. Process according to anyone of the foregoing claims, **characterized** in that at least the longest character string of a data sequence or a data element column, consisting of identical data elements, in particular interfering signs, is eliminated and replaced by fill characters (X'F') and that this character string is described in a descriptor field (24), provided separately for each data sequence, by a pointer, marking the beginning of the character string, by the character string length and by the replaced character.

5. Process according to anyone of the foregoing claims, **characterized** in that respectively for each data element column at least one column descriptor field (24) is provided, that describes, at least partly, the data element column and that data element columns consisting of identical characters are eliminated, replaced by fill characters (X'F') and described in the respective descriptor fields (24) by indication of the respectively replaced character.

6. Process according to claim 5, **characterized** in that at least the longest character string of a data element column consisting of identical data elements is transliberated into a code word which is shorter compared to the respective character string and is replaced by this code word, and that the data element places which have been thereby set free are filled with fill characters (X'F').

7. Process according to claim 5 or 6, **characterized** in that the data elements of a data element column are interlinked by the logical function with the truth table

A x B = W, if A = B and
A x B = B, if A ≠ B

on the condition that B ≠ W, with W being any kind of repetition character.

8. Process according to anyone of the foregoing claims, **characterized** in that each data element of a data element column is transliberated into a valuation or indicator code word, that the indicator code words of the individual data elements of a data column are bit by bit added, that directly adjacent indicator code words are bit by bit EXCLUSIVE-OR interlinked (136), that the linkage results are added, and that both addition results are evaluated for the classification of the data structure, whereby preferably the respective data element column is half characterwise converted into a kind of code words defined by the result of classification.

9. Data processing device for carrying out the process according to anyone of the foregoing claims, **characterized** in that a storage matrix (26) is provided having at its address inputs a first switchover device (36) by which, in dependence on a first switchover signal, the line and column addresses of the data element-storage places can be interchanged and that an index storage (28) is provided whose line number corresponds to that of the storage matrix (26) and which contains the line addresses of the storage matrix (26) in a sorted line sequence.

10. Data processing device according to claim 9, **characterized** in that a second switchover device (38) is provided by which, in dependence on a second switchover signal, the line address inputs of the storage matrix (26) can be activated with the outputs of the index storage (28).

11. Data processing device according to claim 9 or 10, **characterized** in that an attribute and descriptor storage (24) is connected at its address inputs with a third switchover device (40) by which, in dependence on a third switchover signal, the line and column addresses of the storage places can be interchanged.

12. Data processing device for carrying out the process according to claim 8, **characterized** in that a reading storage (76) is provided, containing said indicator code words, which is addressable by the data elements, that a counter arrangement (78) having a double number of individual counters (86, 88) in comparison with the bit number the indicator words is connected with the data output of the reading storage (76) and that half of the individual counters (86, 88) have front end EXCLUSIVE-OR members (94), to the inputs of which respectively one bit position of directly adjacent indicator code words in the reading storage (76) is fed.

13. Data processing device for carrying out the process according to claim 8, **characterized** in that a read only memory (112) is provided as a code memory which is addressable by the data structure classification result of the data column to be compressed and by the respective half character of the respective data column, where the data structure classification result forms the address portion of higher value and the respective half character forms the address portion of lower value.

14. Data processing device according to claim 13, **characterized** in that a comparison circuit (118) that controls a counter (120) is connected with the outputs of a first (114) and a second register (116), and that for the coding of the counter count of the counter (120) in dependence on the kind of stored code words, a multiplexer circuit (122) is provided, containing the code words for coding.

15. Data processing system for carrying out the process according to one of the claims 7 or 8, **characterized** in that an A-register (132) and a B-register (134) are provided, the latter serving also as a result register, that the outputs of both registers (132, 134) are connected bitwise with the inputs of EXCLUSIVE-OR-members (136), and that the outputs of the EXCLUSIVE-OR-members (136) are connected with the inputs of a disjunctive logic member (138), the output signal of which controls the reset input of the B-register (134).

**Revendications**

1. Procédé de compression et de décompression de plusieurs trains de données se composant de données élémentaires et ayant des structures apparentées, en particulier de jeux de calcul de données, suivant lequel les trains de données à structures apparentées et devant être comprimées sont mémorisés en parallèle dans une matrice de mémoires (26), on procède à une analyse de structures de données élémentaires à nombre ordinal coïncidant et caractérisant la position d'une donnée élémentaire à l'intérieur d'un train de données afin d'obtenir une caractéristique liant de multiples données élémentaires de trains de données pour plusieurs trains de données, on utilise pendant la compression un code remplaçant ces données élémentaires et, lors de la décompression, les données élémentaires obtenues par décodage du code sont classées en trains de données en tenant compte dans chaque cas du nombre ordinal correspondant, caractérisé en ce que, avant l'analyse de structure, les longueurs des trains de données mémorisés sont examinées, des groupes de trains de données sont formés avec des trains de données de même longueur et les groupes de trains de données sont classés selon les longueurs croissantes ou décroissantes.

2. Procédé selon la revendication 1, caractérisé en ce que la coïncidence de caractéristique de trains de données classés de même longueur réelle est examinée et ces trains de données sont classés en conséquence, en ce que le numéro de ligne de la matrice de mémoires est décelé pour les trains de données classés de même longueur réelle et de même caractéristique et en ce que ces trains de données sont classés selon le numéro croissant ou décroissant de la ligne de la matrice de mémoires.

3. Procédé selon l'une des revendications précédentes, caractérisé en ce que chaque train de données est complété par une zone d'affectation par attribut (24) qui contient au moins la longueur réelle du train de données, au moins une caractéristique du train de données et le numéro de ligne de la matrice de mémoires, en ce que, dans chaque cas, la dernière donnée élémentaire d'au moins un train de données ainsi qu'éventuellement le nombre de telles données élémentaires (facteur d'itération) sont incorporés dans la zone d'affectation par attribut (24) et en ce que cette dernière donnée élémentaire et son prédécesseur immédiat, coïncidant avec elle, sont éliminés dans le train de données afin d'obtenir un raccourcissement.

4. Procédé selon l'une des revendications précédentes, caractérisé en ce qu'au moins la plus longue chaîne de caractères d'un train de données ou d'une colonne de données élémentaires qui est constituée de mêmes données élémentaires, en particulier de caractères parasites, est éliminée et remplacée par des caractères d'appoint (X', F') et en ce que cette chaîne de caractères est décrite par un indicateur marquant le début de la chaîne de caractères, par la longueur de la chaîne de caractères et par le caractère remplacé dans une zone de descripteur (24) prévue séparément pour chaque train de données.

5. Procédé selon l'une des revendications précédentes, caractérisé en ce que, pour chaque colonne de données élémentaires, il est prévu au moins une zone de descripteur de colonnes (24) qui décrit au moins partiellement la colonne de données élémentaires et en ce que les colonnes de données élémentaires se composant de mêmes caractères sont éliminées, remplacées par des caractères d'appoint (X', F') et décrites dans les zones de descripteur correspondantes (24) par indication dans chaque cas du signe remplacé.

6. Procédé selon la revendication 5, caractérisé en ce qu'au moins la plus longue chaîne de caractères d'une colonne de données élémentaires, qui se compose de données élémentaires identiques, subit une conversion en un mot code qui est plus court que la chaîne de caractères correspondante et est remplacée par ce dernier, et en ce que les emplacements de données élémentaires qui sont alors libérés sont remplis par des caractères d'appoint (X', F').

7. Procédé selon la revendication 5 ou 6, caractérisé en ce que les données élémentaires d'une colonne sont liées par la fonction logique à la table de vérité

A x B = W, si A = B et
A x B = B, si A ≠ B

à la condition que B ≠ W, W étant un caractère quelconque d'itération.

8. Procédé selon l'une des revendications précédentes, caractérisé en ce que chaque donnée élémentaire d'une colonne subit une conversion en un mot code de pondération ou d'indicateur, en ce que les mots code d'indicateur des données élémentaires individuelles d'une colonne de données élémentaires sont additionnés bit par bit, en ce que les mots code d'indicateur immédiatement voisins font l'objet d'une opération logique OU-exclusif bit par bit (136), en ce que les résultats de l'opération logique sont additionnés et en ce que les deux résultats de l'addition sont dépouillés pour la classification de la structure des données, chaque colonne de données élémentaires étant de préférence convertie par demicaractères en un genre de mots code qui est déterminé par le résultat de la classification.

9. Installation de traitement de données pour la mise en oeuvre du procédé selon l'une des revendications précédentes, caractérisée en ce qu'une matrice de mémoires (26) est munie à ses entrées d'adressage d'une première unité de commutation (36) au moyen de laquelle les adresses de lignes et de colonnes des emplacements de mémorisation des données élémentaires sont permutables en fonction d'un premier signal de commutation et en ce qu'il est prévu une mémoire d'indexation (28) dont le nom de ligne coïncide avec celui de la matrice de mémoires (26) et qui contient les adresses de lignes de la matrice de mémoires (26) suivant une séquence de triage.

10. Installation de traitement de données selon la revendication 9, caractérisée en ce qu'il est prévu une seconde unité de commutation (38) au moyen de laquelle les entrées d'adressage de lignes de la matrice de mémoires (26) peuvent être activées par les sorties de la mémoire d'indexation (28) en fonction d'un second signal de commutation.

11. Installation de traitement de données selon la revendication 9 ou 10, caractérisée en ce qu'une mémoire d'attribut et de descripteur (24) est reliée par ses entrées d'adressage à une troisième unité de commutation (40) au moyen de laquelle les adresses de colonnes et de lignes des emplacements de mémorisation sont commutables en fonction d'un troisième signal de commutation.

12. Installation de traitement de données pour la mise en oeuvre du procédé selon la revendication 8, caractérisée en ce qu'il est prévu une mémoire morte (76) contenant les mots code d'indicateur et qui est adressable par les données élémentaires, en ce qu'un ensemble de compteurs (78), dont le nombre des compteurs individuels (86, 88) est le double de celui du nombre de bits du mot code d'indicateur, est connecté à la sortie des données de la mémoire morte (76) et en ce que des circuits OU-exclusif (94) sont branchés en amont de la moitié des compteurs individuels (86, 88), une position de bit de mots code d'indicateur qui sont immédiatement voisins dans la mémoire morte (76) étant dirigée sur les entrées de chacun desdits circuits (94).

13. Installation de traitement de données pour la mise en oeuvre du procédé selon la revendication 8, caractérisée en ce qu'une mémoire fixe (112) est prévue en mémoire de code qui est adressable par le résultat de la classification de la structure de données de la colonne de données devant être comprimée et par le demi-caractère particulier de la colonne de données correspondante , le résultat de la classification de la structure des données formant l'élément d'adressage de poids le plus élevé et chaque demi-caractère correspondant formant l'élément d'adresse de poids le plus bas.

14. Installation de traitement de données selon la revendication 13, caractérisée en ce qu'un circuit comparateur (118) est connecté aux sorties d'un premier (114) et d'un second registre (116), ce circuit comparateur commandant un compteur (120), et en ce qu'un circuit multiplex (122) contenant les mots code de conversion de code est prévu pour la conversion de code, qui est fonction du type des mots code memorisés, du niveau de comptage du compteur (120) qui doit être indiqué.

15. Installation de traitement de données pour la mise en oeuvre du procédé selon l'une des revendications 7 ou 8, caractérisée en ce qu'un registre A (132) et un registre B (134) sont prévus, ce dernier étant aussi utilisé en registre de résultat, en ce que les sorties des deux registres (132, 134) sont connectées bit par bit aux entrées de circuits OU-exclusif (136) et en ce que les sorties des circuits OU-exclusif (136) sont connectées aux entrées d'un circuit logique de réunion (138) dont le signal de sortie commande l'entrée de remise à l'état initial du registre B (134).

EP 0 230 437 B1

```
0000001   X+0000  001C2400  F0F9F3F0  F0F04040  F0F0F0F0  F3F5F0F0  F0F0F0F5  F1F0F3F8 ──── 1.
0000002   X+0000  001C2300  F0F9F2F0  F0F04040  F0F0F0F0  F3F6F0F0  F0F0F0F4  F1F0F3F8 ────┐
0000003   X+0000  001C2200  F0F9F1F0  F0F04040  F0F0F0F0  F1F1F0F0  F0F0F0F3  F1F0F3F7 ──── ②  DATEN-
0000004   X+0000  001C2100  F0F9F0F0  F0F04040  F0F0F0F0  F1F0F0F0  F0F0F0F2  F1F0F3F6 ────┐   ZEILE
0000005   X+0000  001C2000  F0F8F5F0  F0F04040  F0F0F0F0  F1F2F0F0  F0F0F0F1  F1F0F4F5 ──── 3.
0000006   X+0000  001C1F00  F0F8F4F0  F0F04040  F0F0F0F0  F2F2F0F0  F0F0F0F1  F1F0F5F4 ──── 4.
0000007   X+0000  001C1E00  F0F8F3F0  F0F04040  F0F0F0F1  F2F3F0F0  F0F0F0F1  F1F0F4F3
0000008   X+0000  001C1D00  F0F8F2F0  F0F04040  F0F0F0F0  F2F8F0F0  F0F0F0F2  F1F0F4F4
0000009   X+0000  001C1C00  F0F8F1F0  F0F04040  F0F0F0F0  F2F2F0F0  F0F0F0F3  F1F0F4F6
0000010   X+0000  001C1B00  F0F8F0F0  F0F04040  F0F0F0F0  F2F0F0F0  F0F0F0F3  F1F0F4F5
0000011   X+0000  001C1A00  F0F7F3F0  F0F04040  F0F0F0F0  F1F9F0F0  F0F0F0F5  F1F0F4F2
0000012   X+0000  001C1900  F0F7F2F0  F0F04040  F0F0F0F0  F1F8F0F0  F0F0F0F4  F1F0F3F5
0000013   X+0000  001C1800  F0F7F1F0  F0F04040  F0F0F0F0  F1F7F0F0  F0F0F0F3  F1F0F3F4
0000014   X+0000  001C1700  F0F7F0F0  F0F04040  F0F0F0F0  F1F6F0F0  F0F0F0F2  F1F0F3F3
0000015   X+0000  001C1600  F0F6F5F0  F0F04040  F0F0F0F0  F1F5F0F0  F0F0F0F3  F3F0F3F2
0000016   X+0000  001C1500  F0F6F4F0  F0F04040  F0F0F0F0  F1F4F0F0  F0F0F0F5  F1F0F3F6
0000017   X+0000  001C1400  F0F6F3F0  F0F04040  F0F0F0F0  F1F3F0F0  F0F0F0F4  F3F0F4F5
0000018   X+0000  001C1300  F0F6F2F0  F0F04040  F0F0F0F0  F1F2F0F0  F0F0F0F3  F3F0F4F4
0000019   X+0000  001C1200  F0F6F1F0  F0F04040  F0F0F0F0  F1F1F0F0  F0F0F0F2  F4F0F4F3
0000020   X+0000  001C1100  F0F6F0F0  F0F04040  F0F0F0F0  F1F0F0F0  F0F0F0F2  F4F0F4F2
0000021   X+0000  001B0D00  D7C1D9C1  D440D7D3  D6F87E7B  F8407A40  F84BE6C5  D9E37B
0000022   X+0000  001B0C00  D7C1D9C1  D440D7D3  D6F77E7B  F7407A40  F74BE6C5  D9E37B
0000023   X+0000  001B0B00  D7C1D9C1  D440D7D3  D6F67E7B  F6407A40  F64BE6C5  D9E37B
0000024   X+0000  001B0A00  D7C1D9C1  D440D7D3  D6F57E7B  F5407A40  F54BE6C5  D9E37B
0000025   X+0000  001B0900  D7C1D9C1  D440D7D3  D6F47E7B  F4407A40  F44BE6C5  D9E37B
0000026   X+0000  001B0800  D7C1D9C1  D440D7D3  D6F37E7B  F3407A40  F34BE6C5  D9E37B
0000027   X+0000  001B0700  D7C1D9C1  D440D7D3  D6F27E7B  F2407A40  F24BE6C5  D9E37B
0000028   X+0000  001B0600  D7C1D9C1  D440D7D3  D6F17E7B  F1407A40  F14BE6C5  D9E37B
0000029   X+0000  00190000  D7C1D9C1  D440E3C9  E3D37E7B  F3C9D3C9  F3C5E2E3  7B
0000030   X+0000  00170400  D7C1D9C1  D440C1D5  E9C17EF0  F0F0F0F0  F0F0F2
0000031   X+0000  00170300  D7C1D9C1  D440E8D4  C1E77EF0  F0F0F0F0  F0F0F1
0000032   X+0000  00170200  D7C1D9C1  D440E8D3  C9D57EF0  F0F0F0F0  F0F4F5
0000033   X+0000  00150100  D7C1D9C1  D440E8C4  C9D47E7B  F3C5F2F3  7B
0000034   X+0000  00120500  D7C1D9C1  D440D2E4  D9E57ED0  C6D6
0000035   X+0000  00110F00  D7C1D9C1  D440E3C9  D4C57EF1  F8
0000036   X+0000  00110E00  D7C1D9C1  D440E3C9  D4C17EF0  F6
0000037   X+0000  00071000  C5D504
```

1. ② 3. 4. 5. 6. 7. 8.    DATENSPALTE

**FIG. 1**

FIG. 2

**FIG. 3**

**FIG. 4**

FIG. 5

23

— PROGRAMMSPEICHER UND ALLGEMEINE DATEN 64 kBYTE
— INDEXSPEICHER FÜR SPEICHERMATRIX 256 BYTE

— MATRIXSPEICHER 256 * 256 BYTE = 64 kBYTE

— MATRIXSPEICHER SPALTENWEISE (VERTIKAL)

— SPEICHERMATRIX 256 * 1024 BYTE = 256 kBYTE

— SPEICHERMATRIX SPALTENWEISE (VERTIKAL)

— SPEICHERMATRIX SPALTENWEISE INDIZIERT (VERTIKAL)

FIG. 6

RD

84

STEUEREINHEIT

R

ROM
256 * 8 BIT

76

DO - D7

8

SCHNITT-
STELLEN-
KONTROLL-
SCHALTUNG

74

8

8

T1

T3

NORM

T2    T2A

C

RES    +1
ZÄHLER

80

8

NORM

REGISTER E

REGISTER F

8

8

4

8

AUSWAHL
1 AUS 16

16

8 * 2 8-BIT
ZÄHLERANORDNUNG

8

82

78

**FIG. 7**

EO    FO

EXOR

94

T2  EO

T2A

96

NORM

&

90

&

98

AUSWAHL 0

RES    +1
8 BIT ZÄHLER

AUSWAHL 1

RES    +1
8 BIT ZÄHLER

88

8

86

8

BD

BD

100

8

92

8

**FIG. 8**

# FIG. 9

FIG. 10